# EUROPEAN PATENT SPECIFICATION

(11) **EP 2 302 461 B1**
(45) Date of publication and mention of the grant of the patent: **08.06.2016**
(21) Application number: 10178708.3
(22) Date of filing: 23.09.2010
(51) Int. Cl.: G03F 7/32, B41C 1/00

(54) **Method of preparing lithographic printing plate**
Verfahren zur Herstellung einer Lithographiedruckplatte
Procédé de préparation d'une plaque d'impression lithographique

(30) Priority: 24.09.2009 JP 2009219714
(43) Date of publication of application: 30.03.2011
(73) Proprietor: Fujifilm Corporation, Minato-ku Tokyo (JP)
(72) Inventor: Hirano, Mitsunori, Shizuoka (JP)
(74) Representative: Hoffmann Eitle

(56) References cited:
- EP-A1- 1 722 274
- EP-A1- 2 261 033
- EP-A2- 2 166 410
- EP-A2- 2 168 765
- JP-B- 4 150 494

## Description

### Background of the Invention

### 1. Field of the Invention

The present invention relates to a method of preparing a lithographic printing plate, in particular, to a method of preparing a lithographic printing plate which exhibits high processing property and enables processing with one solution or one bath.

### 2. Description of the Related Art

In general, a lithographic printing plate is composed of an oleophilic image area accepting ink and a hydrophilic non-image area accepting dampening water in the process of printing. Lithographic printing is a printing method which comprises rendering the oleophilic image area of the lithographic printing plate to an ink-receptive area and the hydrophilic non-image area thereof to a dampening water-receptive area (ink unreceptive area), thereby making a difference in adherence of ink on the surface of the lithographic printing plate, and depositing the ink only on the image area by utilizing the nature of water and printing ink to repel with each other, and then transferring the ink to a printing material, for example, paper.

In order to prepare the lithographic printing plate, a lithographic printing plate precursor (PS plate) comprising a hydrophilic support having provided thereon an oleophilic photosensitive resin layer (also referred to as a photosensitive layer or an image-recording layer) has heretofore been broadly used. Ordinarily, the lithographic printing plate is obtained by conducting plate making according to a method of exposing the lithographic printing plate precursor through an original, for example, a lith film, and then removing the unnecessary portion of the image-recording layer by dissolving with an alkaline developer or an organic solvent thereby revealing the hydrophilic surface of support to form the non-image area while leaving the image-recording layer in the portion for forming the image area.

Thus, in the hitherto known plate making process of lithographic printing plate precursor, after exposure, the step of removing the unnecessary portion of the image-recording layer by dissolving, for example, with a developer is required. However, in view of the environment and safety, a processing with a developer closer to a neutral range and a small amount of waste liquid are problems to be solved. Particularly, since disposal of waste liquid discharged accompanying the wet treatment has become a great concern throughout the field of industry in view of the consideration for global environment in recent years, the demand for the resolution of the above-described problems has been increased more and more.

On the other hand, digitalized technique of electronically processing, accumulating and outputting image information using a computer has been popularized in recent years, and various new image outputting systems responding to the digitalized technique have been put into practical use. Correspondingly, attention has been drawn to a computer-to-plate (CTP) technique of carrying digitalized image information on highly converging radiation, for example, laser light and conducting scanning exposure of a lithographic printing plate precursor with the light thereby directly preparing a lithographic printing plate without using a lith film. Thus, it is one of important technical subjects to obtain a lithographic printing plate precursor adaptable to the technique described above.

As described above, the decrease in alkali concentration of developer and the simplification of processing step have been further strongly required from both aspects of the consideration for global environment and the adaptation for space saving and low running cost. However, since hitherto known development processing comprises three steps of developing with an aqueous alkali solution having pH of 10 or more, washing of the alkali agent with a water-washing bath and then treating with a gum solution mainly comprising a hydrophilic resin as described above, an automatic developing machine per se requires a large space and problems of the environment and running cost, for example, disposal of the development waste liquid, water-washing waste liquid and gum waste liquid still remain.

For example, in Patent Document 1 (JP-A-2002-91016 (the term "JP-A" as used herein means an "unexamined published Japanese patent application")) a method of developing with a developer which contains an inorganic alkali agent and a nonionic surfactant having a polyoxyalkylene ether group and has pH of 10.0 to 12.5 and conductivity of 3 to 30 mS/cm is described. However, the method has a problem in that the development can not be carried out at pH lower than the range described above, because the photosensitive layer contains an alkali-soluble resin. Further, the method requires the post-processing, for example, water washing or treatment with a gum solution.

Also, a processing with a processing solution which has pH of 11.9 to 12.1 and contains a water-soluble polymer compound is described in the example of Patent Document 2. However, since the lithographic printing plate obtained by the processing is left in the state that the alkali of pH 12 adheres on the surface thereof, a problem in view of safety of an operator arises and also another problem occurs in that with the lapse of long time after the preparation of the lithographic printing plate until the initiation of printing, the image area gradually dissolves to cause the deterioration in printing durability or ink-receptive property.
Patent Document 1: JP-A-2002-91016
Patent Document 2: EP-A-1868036

EP-A-2166410, EP-A-2261033 and EP-A-2168765, which represent prior art pursuant to Article 54(3) EPC, disclose methods for the production of a lithographic printing plate using a developer containing a polyoxyethylene phenyl ether and a polyoxyethylene lauryl ether. The latter compound contains 10 oxyethylene units.

### Summary of the Invention

Therefore, an object of the present invention is to provide a method of preparing a lithographic printing plate which overcomes the problems of the prior art. More specifically, the object of the present invention is to provide a method of preparing a lithographic printing plate which exhibits safety and excellent processing property, provides a lithographic printing plate prevented from deterioration of printing durability and occurrence of stain in the non-image area, uses a developer which is excellent in solubility and prevents occurrence of turbidity even when preserved for a long period of time, and enables one-bath processing.

As a result of the intensive investigations, the inventor has found that the above-described object can be achieved by the method described below to complete the present invention.
[1] A method for preparing a lithographic printing plate comprising the steps of:
   exposing to laser light a lithographic printing plate precursor comprising a support; an image-recording layer containing (A) a sensitizing dye, (B) a polymerization initiator, (C) a polymerizable compound and (D) a binder polymer; and a protective layer in this order; and
   removing the protective layer and an unexposed area of the image-recording layer using a developer containing a compound represented by formula (1) below and a compound represented by formula (2) below, wherein the exposed precursor is not subjected to a water washing step before or after the removal step:

      X-Y-O-(A1)ₙ₁-(B1)ₘ₁-H (1)

      wherein X represents an aromatic group, Y represents a single bond or an alkylene group having 1-10 carbon atoms, A1 and B1 are different from each other and each represents -CH₂CH₂O- or -CH₂CH(CH₃)O-, and n1 and m1 each represents an integer of 0-100, provided that the sum total of n1 and m1 is 12-28;

      Z-L-(A2)ₙ₂-(B2)ₘ₂-H (2)

      wherein Z represents an alkyl group having 1-20 carbon atoms, L represents -O- or - COO-, A2 and B2 are different from each other and each represents -CH₂CH₂O- or - CH₂CH(CH₃)O-, and n2 and m2 each represents an integer of 0-100, provided that the sum total of n2 and m2 is 12-28.
[2] A method according to [1], wherein the ratio of the weight of the compound represented by formula (1) in the developer to the weight of the compound represented by formula (2) in the developer is 1:99-99:1.
[3] A method according to [1] or [2], wherein the pH of the developer is 2-11.
[4] A method according to any of [1]-[3], wherein the developer contains an organic solvent.
[5] A method according to any of [1]-[4], wherein the developer contains a carbonate ion and a hydrogen carbonate ion.
[6] A method according to any of [1]-[4], wherein the developer contains a water-soluble amine and an ammonium ion thereof.
[7] A method according to any of [1]-[6], wherein the developer contains a water-soluble polymer compound.
[8] A method according to any of [1]-[7], wherein the sensitizing dye is at least one of the compounds represented by formulae (V), (VI) and (IX) below: 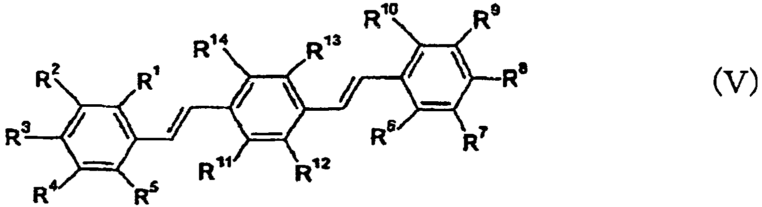 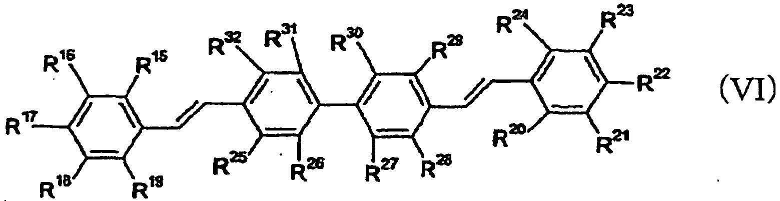 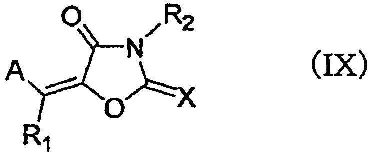
   wherein, in formula (V), R¹-R¹⁴ each independently represents a hydrogen atom, an alkyl group, an alkoxy group, a cyano group or a halogen atom, provided that at least one of R¹-R¹⁰ represents an alkoxy group having 2 or more carbon atoms;
   in formula (VI), R¹⁵-R³² each independently represents a hydrogen atom, an alkyl group, an alkoxy group, a cyano group or a halogen atom, provided that at least one of R¹⁵-R²⁴ represents an alkoxy group having 2 or more carbon atoms; and
   in formula (IX), A represents an aromatic group or a heterocyclic group, X represents an oxygen atom, a sulfur atom or =N(R₃), R₁, R₂ and R₃ each independently represents a monovalent non-metallic atomic group, and A and R₁ or R₂ and R₃ may be combined with each other to form an aliphatic or aromatic ring.
[9] A method according to any of [1]-[8], wherein the binder polymer is a (meth)acrylic polymer or a polyvinyl butyral resin.
[10] A developer comprising a compound represented by formula (1) below and a compound represented by formula (2) below:

   X-Y-O-(A1)ₙ₁-(B1)ₘ₁-H (1)

   wherein X represents an aromatic group, Y represents a single bond or an alkylene group having 1-10 carbon atoms, A1 and B1 are different from each other and each represents -CH₂CH₂O- or -CH₂CH(CH₃)O-, and n1 and m1 each represents an integer of 0-100, provided that the sum total of n1 and m1 is 12-28;

   Z-L-(A2)ₙ₂(B2)ₘ₂-H (2)

   wherein Z represents an alkyl group having 1-20 carbon atoms, L represents -O- or-COO-, A2 and B2 are different from each other and each represents -CH₂CH₂O- or - CH₂CH(CH₃)O-, and n2 and m2 each represents an integer of 0-100, provided that the sum total of n2 and m2 is 12-28.

### Brief Description of the Drawing

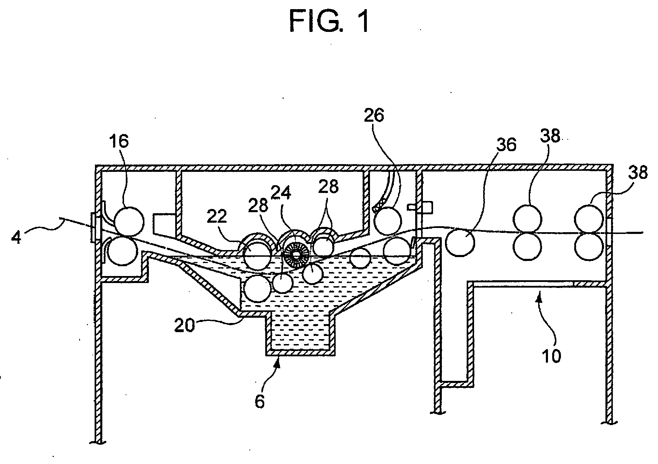

Fig. 1 is a view schematically showing a configuration of an automatic developing machine.

### Description of reference numerals and signs

- 4:: Lithographic printing plate precursor
- 6:: Developing unit
- 10:: Drying unit
- 16:: Transport roller
- 20:: Developing tank
- 22:: Transport roller
- 24:: Brush roller
- 26:: Squeeze roller
- 28:: Backup roller
- 36:: Guide roller
- 38:: Skewer roller

### Detailed Description of the Invention

The method of preparing a lithographic printing plate according to the invention will be described in detail below.

### [Lithographic printing plate precursor]

The lithographic printing plate precursor for use in the method of preparing a lithographic printing plate according to the invention comprises a support having thereon an image-recording layer containing (A) a sensitizing dye, (B) a polymerization initiator, (C) a polymerizable compound and (D) a binder polymer, and a protective layer in this order. The lithographic printing plate precursor may comprise, for example, an undercoat layer or a backcoat layer, if desired.

### [Image-recording layer]

The constituting components of the image-recording layer (hereinafter, also referred to as a photosensitive layer) will be described below.

### (A) Sensitizing dye

The sensitizing dye can be used without particular limitation as far as it absorbs light at the image exposure to form the excited state and provides energy to the polymerization initiator described hereinafter with electron transfer, energy transfer or heat generation thereby improving the polymerization initiation function. Particularly, a sensitizing dye having an absorption maximum in a wavelength range of 300 to 450 nm or 750 to 1,400 nm is preferably used.

Examples of the sensitizing dye having an absorption maximum in a wavelength range of 300 to 450 nm include merocyanine dyes, benzopyranes, coumarins, aromatic ketones and anthracenes.

Of the sensitizing dyes having an absorption maximum in a wavelength range of 300 to 450 nm, a dye represented by formula (IX) shown below is more preferred in view of high sensitivity.

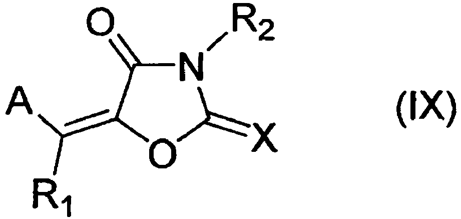

In formula (IX), A represents an aromatic cyclic group or a heterocyclic group, X represents an oxygen atom, a sulfur atom or =N(R₃), and R₁, R₂ and R₃ each independently represents a monovalent non-metallic atomic group, or A and R₁ or R₂ and R₃ may be combined with each other to form an aliphatic or aromatic ring.

In formula (IX), R₁, R₂ and R₃ each independently represents a monovalent non-metallic atomic group, preferably a substituted or unsubstituted alkyl group, a substituted or unsubstituted alkenyl group, a substituted or unsubstituted aryl group, a substituted or unsubstituted aromatic heterocyclic residue, a substituted or unsubstituted alkoxy group, a substituted or unsubstituted alkylthio group, a hydroxy group or a halogen atom. Specific examples of R₁, R₂ and R₃ include groups described in Paragraph Nos. [0035] to [0043] of JP-A-2007-58170.

The aromatic cyclic group or heterocyclic group represented by A may have a substituent. The aromatic cyclic group and heterocyclic group which may have a substituent are same as the substituted or unsubstituted aryl group and substituted or unsubstituted aromatic heterocyclic residue described for R₁, R₂ and R₃, respectively.

Specific examples of the sensitizing dye preferably used include compounds described in Paragraph Nos. [0047] to [0053] of JP-A-2007-58170.

Further, a sensitizing dye represented by formula (V) or (VI) shown below can also be used.

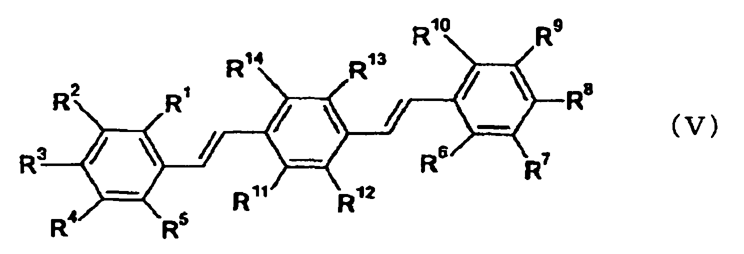

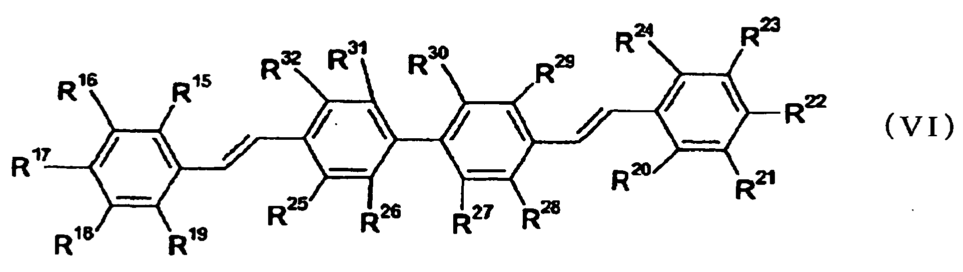

In formula (V), R¹ to R¹⁴ each independently represents a hydrogen atom, an alkyl group, an alkoxy group, a cyano group or a halogen atom, provided that at least one of R¹ to R¹⁰ represents an alkoxy group having 2 or more carbon atoms.

In formula (VI), R¹⁵ to R³² each independently represents a hydrogen atom, an alkyl group, an alkoxy group, a cyano group or a halogen atom, provided that at least one of R¹⁵ to R²⁴ represents an alkoxy group having 2 or more carbon atoms.

Specific examples of such sensitizing dye preferably used include compounds described in WO 2005/029187.

Further, sensitizing dyes described in JP-A-2007-171406, JP-A-2007-206216, JP-A-2007-206217, JP-A-2007-225701, JP-A-2007-225702, JP-A-2007-316582 and JP-A-2007-328243 are also preferably used.

The sensitizing dye having an absorption maximum in a wavelength range of 750 to 1,400 nm (hereinafter, also referred to as an "infrared absorbing agent") preferably used in the invention is described in detail below. The infrared absorbing agent used is preferably a dye or pigment.

As the dye, commercially available dyes and known dyes described in literatures, for example, Senryo Binran (Dye Handbook) compiled by The Society of Synthetic Organic Chemistry, Japan (1970) can be used. Specifically, the dyes includes azo dyes, metal complex azo dyes, pyrazolone azo dyes, naphthoquinone dyes, anthraquinone dyes, phthalocyanine dyes, carbonium dyes, quinoneimine dyes, methine dyes, cyanine dyes, squarylium dyes, pyrylium salts and metal thiolate complexes.

Of the dyes, cyanine dyes, squarylium dyes, pyrylium dyes, nickel thiolate complexes and indolenine cyanine dyes are particularly preferred. Further, cyanine dyes and indolenine cyanine dyes are more preferred. As particularly preferable examples of the dye, cyanine dyes represented by formula (a) shown below are exemplified.

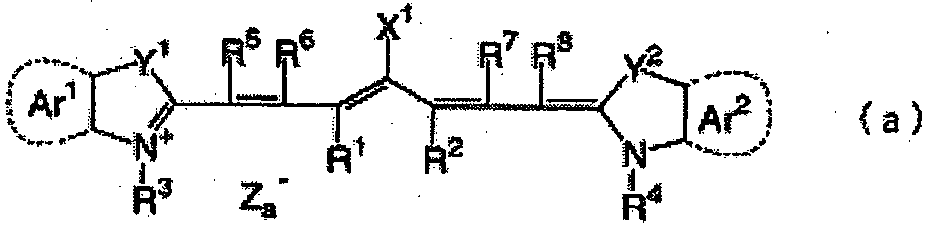

In formula (a), X¹ represents a hydrogen atom, a halogen atom, -NPh₂, X²-L¹ or a group shown below. X² represents an oxygen atom, a nitrogen atom or a sulfur atom, L¹ represents a hydrocarbon group having from 1 to 12 carbon atoms, an aromatic cyclic group containing a hetero atom (a nitrogen atom, a sulfur atom, an oxygen atom, a halogen atom or a selenium atom) or a hydrocarbon group having from 1 to 12 carbon atoms and containing a hetero atom. Xa⁻ has the same meaning as Za⁻ defined hereinafter. R^{a} represents a hydrogen atom or a substituent selected from an alkyl group, an aryl group, a substituted or unsubstituted amino group and a halogen atom.

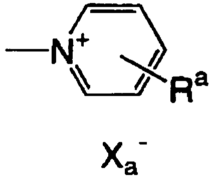

R¹ and R² each independently represents a hydrocarbon group having from 1 to 12 carbon atoms. In view of the preservation stability of a coating solution for photosensitive layer, it is preferred that R¹ and R² each represents a hydrocarbon group having two or more carbon atoms and it is also preferred that R¹ and R² are combined with each other to form a 5-membered or 6-membered ring.

Ar¹ and Ar², which may be the same or different, each represents an aromatic hydrocarbon group which may have a substituent. Preferable examples of the aromatic hydrocarbon group include a benzene ring group and a naphthalene ring group. Preferable examples of the substituent include a hydrocarbon group having 12 or less carbon atoms, a halogen atom and an alkoxy group having 12 or less carbon atoms. Y¹ and Y², which may be the same or different, each represents a sulfur atom or a dialkylmethylene group having 12 or less carbon atoms. R³ and R⁴, which may be the same or different, each represents a hydrocarbon group having 20 or less carbon atoms, which may have a substituent. Preferable examples of the substituent include an alkoxy group having 12 or less carbon atoms, a carboxyl group and a sulfo group. R⁵, R⁶, R⁷ and R⁸, which may be the same or different, each represents a hydrogen atom or a hydrocarbon group having 12 or less carbon atoms. From the standpoint of the availability of raw materials, a hydrogen atom is preferred. Za⁻ represents a counter anion. However, Za⁻ is not necessary when the cyanine dye represented by formula (a) has an anionic substituent in the structure thereof and the neutralization of charge is not needed. Preferable examples of the counter ion for Za⁻ include a halide ion, a perchlorate ion, a tetrafluoroborate ion, a hexafluorophosphate ion and a sulfonate ion, and particularly preferable examples thereof include a perchlorate ion, a hexafluorophosphate ion and an arylsulfonate ion in view of the preservation stability of a coating solution for photosensitive layer.

Specific examples of the cyanine dye represented by formula (a) which can be preferably used in the invention include those described in Paragraph Nos. [0017] to [0019] of JP-A-2001-133969.

Further, other particularly preferable examples of the dye include specific indolenine cyanine dyes described in JP-A-2002-278057.

Examples of the pigment for use in the invention include commercially available pigments and pigments described in Colour Index (C.I.), Saishin Ganryo Binran (Handbook of the Newest Pigments) compiled by Pigment Technology Society of Japan (1977), Saishin Ganryo Oyou Gijutsu (Newest Application on Technologies for Pigments), CMC Publishing Co., Ltd. (1986) and Insatsu Ink Gijutsu (Printing Ink Technology), CMC Publishing Co., Ltd. (1984).

The amount of the sensitizing dye added is preferably in a range from 0.05 to 30 parts by mass, more preferably from 0.1 to 20 parts by mass, most preferably from 0.2 to 10 parts by mass, per 100 parts by mass of the total solid content of the photosensitive layer. (B) Polymerization initiator

The photosensitive layer according to the invention contains a polymerization initiator (hereinafter, also referred to as an initiator compound). A radical polymerization initiator is preferably used in the invention.

As the initiator compound according to the invention, initiator compounds known to those skilled in the art can be used without limitation. Specifically, the initiator compound includes, for example, a trihalomethyl compound, a carbonyl compound, an organic peroxide, an azo compound, an azide compound, a metallocene compound, a hexaarylbiimidazole compound, an organic boron compound, a disulfone compound, an oxime ester compound, an onium salt compound and a iron arene complex. Among them, at least one compound selected from the hexaarylbiimidazole compound, onium salt compound, trihalomethyl compound and metallocene compound is preferable, and the hexaarylbiimidazole compound is particularly preferable. The polymerization initiators may be appropriately used in combination of two or more thereof.

The hexaarylbiimidazole compound includes, for example, lophine dimers described in JP-B-45-37377 (the term "JP-B" as used herein means an "examined Japanese patent publication") and JP-B-44-86516, specifically, 2,2'-bis(o-chlorophenyl)-4,4',5,5'-tetraphenylbiimidazole, 2,2'-bis(o-bromophenyl)-4,4',5,5'-tetraphenylbiimidazole, 2,2'-bis(o,p-dichlorophenyl)-4,4',5,5'-tetraphenylbiimidazole, 2,2'-bis(o-chlorophenyl)-4,4',5,5'-tetra(m-methoxyphenyl)biimidazole, 2,2'-bis(o,o'-dichlorophenyl)-4,4',5,5'-tetraphenylbiimidazole, 2,2'-bis(o-nitrophenyl)-4,4',5,5'-tetraphenylbiimidazole, 2,2'-bis(o-methylphenyl)-4,4',5,5'-tetraphenylbiimidazole and 2,2'-bis(o-trifluoromethylphenyl)-4,4',5,5'-tetraphenylbiimidazole.

The hexaarylbiimidazole compound is particularly preferably used together with the sensitizing dye having an absorption maximum in a wavelength range of 300 to 450 nm.

The onium salt preferably used in the invention includes a sulfonium salt, an iodonium salt and a diazonium salt. Particularly, a diaryliodonium salt and a triarylsulfonium salt are preferably used. The onium salt is particularly preferably used together with the infrared absorbing agent having an absorption maximum in a wavelength range of 750 to 1,400 nm.

Further, polymerization initiators described in Paragraph Nos. [0071] to [0129] of JP-A-2007-206217 are preferably used.

The polymerization initiators are preferably used individually or in combination of two or more thereof according to the invention.

The amount of the polymerization initiator used in the photosensitive layer according to the invention is preferably from 0.01 to 20% by mass, more preferably from 0.1 to 15% by mass, still more preferably from 1.0 to 10% by mass, based on the total solid content of the photosensitive layer. (C) Polymerizable compound

The polymerizable compound for use in the photosensitive layer according to the invention is preferably an addition-polymerizable compound having at least one ethylenically unsaturated double bond, and it is selected from compounds having at least one, preferably two or more, terminal ethylenically unsaturated double bonds. The polymerizable compound has a chemical form, for example, a monomer, a prepolymer, specifically, a dimer, a trimer or an oligomer, or a mixture thereof. Examples of the monomer include an unsaturated carboxylic acid (for example, acrylic acid, methacrylic acid, itaconic acid, crotonic acid, isocrotonic acid or maleic acid) and an ester or amide thereof. Preferably, an ester of an unsaturated carboxylic acid with a polyhydric alcohol compound and an amide of an unsaturated carboxylic acid with a polyvalent amine compound are used. An addition reaction product of an unsaturated carboxylic acid ester or amide having a nucleophilic substituent, for example, a hydroxy group, an amino group or a mercapto group, with a monofunctional or polyfunctional isocyanate or epoxy compound, or a dehydration condensation reaction product of the unsaturated carboxylic acid ester or amide with a monofunctional or polyfunctional carboxylic acid is also preferably used. Moreover, an addition reaction product of an unsaturated carboxylic acid ester or amide having an electrophilic substituent, for example, an isocyanate group or an epoxy group with a monofunctional or polyfunctional alcohol, amine or thiol, or a substitution reaction product of an unsaturated carboxylic acid ester or amide having a releasable substituent, for example, a halogen atom or a tosyloxy group with a monofunctional or polyfunctional alcohol, amine or thiol is also preferably used. In addition, compounds in which the unsaturated carboxylic acid described above is replaced by an unsaturated phosphonic acid, styrene, vinyl ether or the like can also be used.

Specific examples of the monomer, which is an ester of a polyhydric alcohol compound with an unsaturated carboxylic acid, include, as an acrylic acid ester, for example, ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO) modified triacrylate and polyester acrylate oligomer. As a methacrylic acid ester, for example, tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl]dimethylmethane and bis[p-(methacryloxyethoxy)phenyl]dimethylmethane are exemplified. Specific examples of the monomer, which is an amide of a polyvalent amine compound with an unsaturated carboxylic acid, include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide and xylylene bismethacrylamide.

Urethane type addition-polymerizable compounds produced using an addition reaction between an isocyanate and a hydroxy group are also preferably used, and specific examples thereof include vinylurethane compounds having two or more polymerizable vinyl groups per molecule obtained by adding a vinyl monomer containing a hydroxy group represented by formula (A) shown below to a polyisocyanate compound having two or more isocyanate groups per molecule, described in JP-B-48-41708.

CH₂=C(R₄)COOCH₂CH(R₅)OH (A)

wherein R₄ and R₅ each independently represents H or CH₃.

Also, urethane acrylates described in JP-A-51-37193, JP-B-2-32293 and JP-B-2-16765, and urethane compounds having an ethylene oxide skeleton described in JP-B-58-49860, JP-B-56-17654, JP-B-62-39417 and JP-B-62-39418 are preferably used.

Further, photo-oxidizable polymerizable compounds described in JP-T-2007-506125 (the term "JP-T" as used herein means a published Japanese translation of a PCT patent application) are also preferred and polymerizable compounds having at least one urea group and/or tertiary amino group are particularly preferred. Specifically, the compound set force below is exemplified.

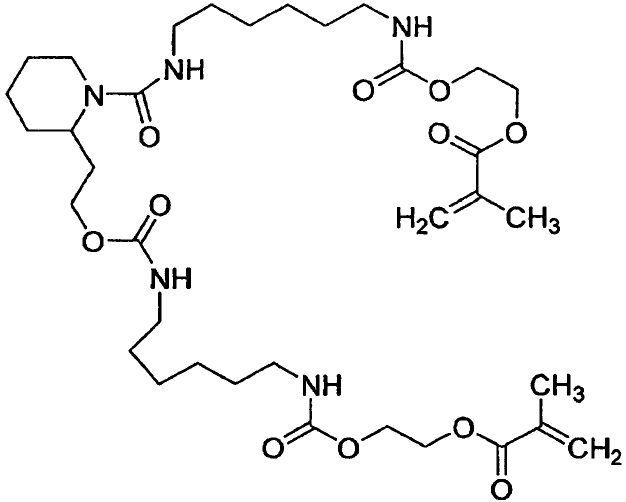

Details of the method of using the polymerizable compound, for example, selection of the structure, individual or combination use or an amount added, can be appropriately determined in accordance with the characteristic design of the final lithographic printing plate precursor. The polymerizable compound is used preferably in a range of 5 to 75% by mass, more preferably in a range of 25 to 70% by mass, particularly preferably in a range of 30 to 60% by mass, based on the total solid content of the photosensitive layer.

### (D) Binder polymer

The photosensitive layer according to the invention contains a binder polymer. As the binder polymer, a polymer capable of holding the components of photosensitive layer on a support and capable of being removed by the developer is used. The binder polymer used includes a (meth)acrylic polymer, a polyurethane resin, a polyvinyl alcohol resin, a polyvinyl butyral resin, a polyvinyl formal resin, a polyamide resin, a polyester resin and an epoxy resin. Particularly, a (meth)acrylic polymer, a polyurethane resin and a polyvinyl butyral resin are preferably used.

The term "(meth)acrylic polymer" as used herein means a copolymer containing as a polymerization component, (meth)acrylic acid or a (meth)acrylic acid derivative, for example, a (meth)acrylate (including, for example, an alkyl ester, aryl ester and allyl ester), (meth)acrylamide or a (meth)acrylamide derivative.

The term "polyurethane resin" as used herein means a polymer formed by a condensation reaction of a compound having two or more isocyanate groups and a compound having two or more hydroxy groups.

The term "polyvinyl butyral resin" as used herein means a polymer synthesized by a reaction (acetalization reaction) of polyvinyl alcohol obtained by partial or full saponification of polyvinyl acetate with butylaldehyde under an acidic condition and also includes a polymer wherein an acid group or the like is introduced, for example, by a method of reacting the remaining hydroxy group with a compound having the acid group or the like.

One preferable example of the binder polymer according to the invention is a copolymer containing a repeating unit having an acid group. Examples of the acid group include a carboxylic acid group, a sulfonic acid group, a phosphonic acid group, a phosphoric acid group and a sulfonamido group. Particularly, a repeating unit having a carboxylic acid group is preferred, and a repeating unit derived from (meth)acrylic acid or a repeating unit represented by formula (I) shown below is preferably used.

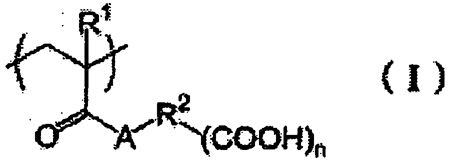

In formula (I), R¹ represents a hydrogen atom or a methyl group, R² represents a single bond or an n+1 valent connecting group, A represents an oxygen atom or -NR³-, wherein R³ represents a hydrogen atom or a monovalent hydrocarbon group having from 1 to 10 carbon atoms, and n represents an integer of 1 to 5.

The connecting group represented by R² in formula (I) is constructed from a carbon atom, a hydrogen atom, an oxygen atom, a nitrogen atom, a sulfur atom and a halogen atom and preferably contains from 1 to 80 atoms. Specific examples of the connecting group include an alkylene group, a substituted alkylene group, an arylene group and a substituted arylene group. The connecting group may have a structure wherein a plurality of such divalent groups is connected to each other via an amido bond or an ester bond. R² is preferably a single bond, an alkylene group or a substituted alkylene group, more preferably a single bond, an alkylene group having from 1 to 5 carbon atoms or a substituted alkylene group having from 1 to 5 carbon atoms, and most preferably a single bond, an alkylene group having from 1 to 3 carbon atoms or a substituted alkylene group having from 1 to 3 carbon atoms.

Examples of the substituent include a monovalent non-metallic atomic group exclusive of a hydrogen atom, for example, a halogen atom (e.g., -F, -Br, -Cl or -I), a hydroxy group, an alkoxy group, an aryloxy group, a mercapto group, an acyl group, a carboxyl group and a conjugate base group thereof, an alkoxycarbonyl group, an aryloxycarbonyl group, a carbamoyl group, an aryl group, an alkenyl group and an alkynyl group.

R³ is preferably a hydrogen atom or a hydrocarbon group having from 1 to 5 carbon atoms, more preferably a hydrogen atom or a hydrocarbon group having from 1 to 3 carbon atoms, and most preferably a hydrogen atom or a methyl group. n is preferably from 1 to 3, more preferably 1 or 2, and most preferably 1.

A ratio (% by mol) of the copolymerization component having a carboxylic acid group in the total copolymerization components of the binder polymer is preferably from 1 to 70% in view of developing property. Considering good compatibility between the developing property and printing durability, it is more preferably from 1 to 50%, and particularly preferably from 1 to 30%.

Further, a polyvinyl butyral resin having an acid group introduced, for example, a resin represented by formula (II) shown below is also preferably used.

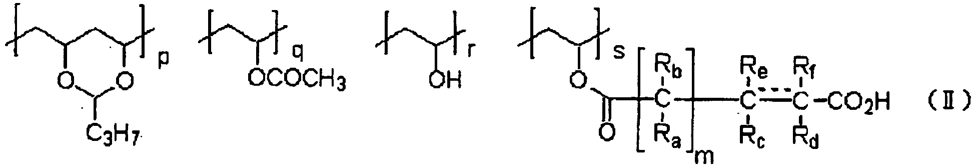

In formula (II), a ratio of each repeating unit p/q/r/s is preferably in a range from 50 to 78% by mol/from 1 to 5% by mol/from 5 to 28% by mol/from 5 to 20% by mol. Rₐ, R_{b}, R_{c}, R_{d}, Rₑ and R_{f} each independently represents a monovalent substituent which may have a substituent or a hydrogen atom, and m represents 0 or 1. Preferable examples of any one of Rₐ, R_{b}, R_{c}, R_{d}, Rₑ and R_{f} include a hydrogen atom, an alkyl group which may have a substituent, a halogen atom and an aryl group which may have a substituent. More preferable examples thereof include a hydrogen atom, a straight-chain alkyl group, for example, a methyl group, an ethyl group or a propyl group, an alkyl group substituted with a carboxylic acid, a halogen atom, a phenyl group and a phenyl group substituted with a carboxylic acid. R_{c} and R_{d} or Rₑ and R_{f} may form a ring structure. The bond between the carbon atom to which R_{c} and Rₑ connect and the carbon atom to which R_{d} and R_{f} connect is a single bond, a double bond or an aromatic double bond and in the case of the double bond or aromatic double bond, R_{c} and R_{d}, Rₑ and R_{f}, R_{c} and R_{f} or Rₑ and R_{d} are connected with each other to from a single bond.

Preferable specific examples of the repeating unit having a carboxylic acid group are set forth below.

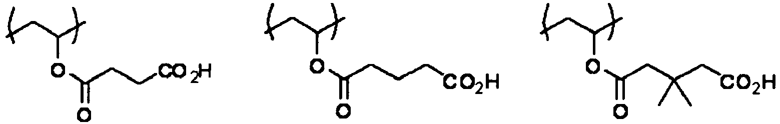

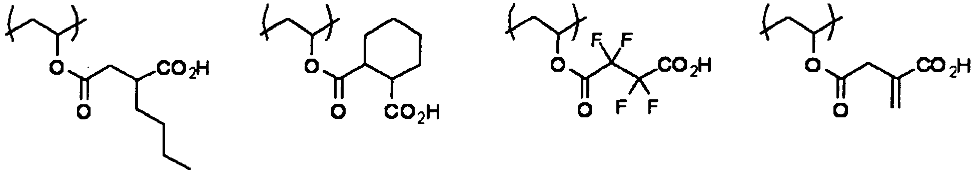

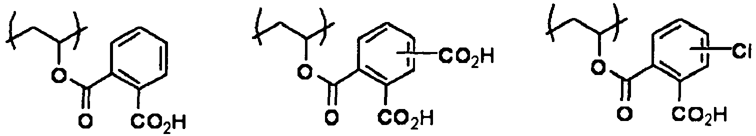

The acid group of a polymer having an acid group which is a preferable example of the binder polymer according to the invention may be neutralized with a basic compound. Particularly, it is preferred to be neutralized with a compound having a basic nitrogen atom, for example, an amino group, an amidine group or a guanidine group. It is also preferred that the compound having a basic nitrogen atom has an ethylenically unsaturated group. Specific examples of the compound include compounds described in WO 2007/057442.

It is preferred that the binder polymer for use in the invention further contains a crosslinkable group. The term "crosslinkable group" as used herein means a group capable of crosslinking the binder polymer in the process of a radical polymerization reaction which is caused in the photosensitive layer, when the lithographic printing plate precursor is exposed to light. The crosslinkable group is not particularly restricted as long as it has such a function and includes, for example, an ethylenically unsaturated bond group, an amino group or an epoxy group as a functional group capable of undergoing an addition polymerization reaction. Also, a functional group capable of forming a radical upon irradiation with light may be used and such a crosslinkable group includes, for example, a thiol group and a halogen atom. Among them, the ethylenically unsaturated bond group is preferred. The ethylenically unsaturated bond group preferably includes a styryl group, a (meth)acryloyl group and an allyl group.

In the binder polymer, for example, a free radical (a polymerization initiating radical or a propagating radical in the process of polymerization of the polymerizable compound) is added to the crosslinkable functional group to cause addition polymerization between the polymers directly or through a polymerization chain of the polymerizable compound and as a result, crosslinking is formed between the polymer molecules to effect curing. Alternatively, an atom (for example, a hydrogen atom on the carbon atom adjacent to the functional crosslinkable group) in the polymer is withdrawn by a free radical to produce a polymer radical and the polymer radicals combine with each other to form crosslinking between the polymer molecules to effect curing.

The content of the crosslinkable group (content of radical-polymerizable unsaturated double bond determined by iodine titration) in the binder polymer is preferably from 0.01 to 10.0 mmol, more preferably from 0.05 to 5.0 mmol, most preferably from 0.1 to 2.0 mmol, per g of the binder polymer.

The binder polymer for use in the invention may contain a polymerization unit of alkyl (meth)acrylate or aralkyl (meth)acrylate besides the polymerization unit having an acid group and the polymerization unit having a crosslinkable group. The alkyl group in the alkyl (meth)acrylate is preferably an alkyl group having from 1 to 5 carbon atoms and more preferably a methyl group. The aralkyl (meth)acrylate includes, for example, benzyl (meth)acrylate.

The binder polymer preferably has a mass average molecular weight of 5,000 or more, more preferably from 10,000 to 300,000, and a number average molecular weight of 1,000 or more, more preferably from 2,000 to 250,000. The polydispersity (weight average molecular weight/number average molecular weight) is preferably from 1.1 to 10.

The binder polymers may be used individually or in combination of two or more thereof. The content of the binder polymer is preferably from 5 to 75% by mass, more preferably from 10 to 70% by mass, still more preferably from 10 to 60% by mass, based on the total solid content of the photosensitive layer from the standpoint of good strength of the image area and good image-forming property.

The total content of the polymerizable compound and the binder polymer is preferably 80% by mass or less based on the total solid content of the photosensitive layer. When it exceeds 80% by mass, decrease in the sensitivity and deterioration in the developing property may be caused sometimes. The total content is more preferably from 35 to 75% by mass.

According to the invention, by controlling a ratio of the polymerizable compound to the binder polymer contained in the photosensitive layer of the lithographic printing plate precursor, the permeability of developer into the photosensitive layer more increases and the developing property is further improved. Specifically, a weight ration of polymerizable compound/binder polymer in the photosensitive layer is preferably 1.2 or more, more preferably from 1.25 to 4.5, and particularly preferably from 2 to 4.

### <Other components for photosensitive layer>

The photosensitive layer according to the invention preferably further contains a chain transfer agent. As the chain transfer agent, for example, compounds having SH, PH, SiH or GeH in their molecules are used. The compound donates hydrogen to a low active radical species to generate a radical or is oxidized and deprotonized to generate a radical.

In particular, a thiol compound (for example, a 2-mercaptobenzimidazole, a 2-mercaptobenzothiazole, a 2-mercaptobenzoxazole, a 3-mercaptotriazole or a 5-mercaptotetrazole) is preferably used as the chain transfer agent in the photosensitive layer according to the invention.

Into the photosensitive layer according to the invention, various additives can be further incorporated, if desired. Examples of the additive include a surfactant for progressing the developing property and improving the surface state of coated layer, a microcapsule for providing good compatibility between developing property and printing durability, a hydrophilic polymer for improving the developing property and dispersion stability of microcapsule, a coloring agent or print-out agent for visually distinguishing the image area from the non-image area, a polymerization inhibitor for preventing undesirable thermal polymerization of the radical polymerizable compound during the production and preservation of the photosensitive layer, a higher fatty acid derivative for avoiding polymerization inhibition due to oxygen, a fine inorganic particle for increasing strength of the cured layer in the image area, a hydrophilic low molecular weight compound for improving the developing property, a co-sensitizer for increasing sensitivity and a plasticizer for improving plasticity. As the additives, known compounds are used and, for example, compounds described in Paragraph Nos. [0161] to [0215] of JP-A-2007-206217 are used.

### <Formation of photosensitive layer>

The photosensitive layer according to the invention is formed by dispersing or dissolving each of the necessary constituting components described above in a solvent to prepare a coating solution and coating the solution. The solvent used include, for example, methyl ethyl ketone, ethylene glycol monomethyl ether, 1-methoxy-2-propanol, 2-methoxyethyl acetate, 1-methoxy-2-propyl acetate and γ-butyrolactone, but the invention should not be construed as being limited thereto. The solvents may be used individually or as a mixture. The solid content concentration of the coating solution is preferably from 1 to 50% by mass.

The coating amount (solid content) of the photosensitive layer on the support after the coating and drying is preferably from 0.3 to 3.0 g/m². Various methods can be used for the coating. Examples of the method include bar coater coating, spin coating, spray coating, curtain coating, dip coating, air knife coating, blade coating and roll coating.

### <Protective layer>

In the lithographic printing plate precursor according to the invention, a protective layer (oxygen-blocking layer) is provided on the photosensitive layer in order to prevent diffusion and penetration of oxygen which inhibits the polymerization reaction at the time of exposure. As a material used in the protective layer, for example, a water-soluble polymer compound relatively excellent in crystallizability is preferably used. Specifically, when polyvinyl alcohol is used as a main component, the best results can be obtained in the fundamental characteristics, for example, oxygen-blocking property and removability by development.

Polyvinyl alcohol for use in the protective layer may be partially substituted with ester, ether or acetal as long as it contains unsubstituted vinyl alcohol units for achieving the necessary oxygen-blocking property and solubility in water. Also, polyvinyl alcohol may partly have other copolymer component. Polyvinyl alcohol is obtained by hydrolysis of polyvinyl acetate. As specific examples of the polyvinyl alcohol, those having a hydrolysis degree of 71 to 100% by mole and a polymerization repeating unit number of 300 to 2,400 are exemplified. Specific examples thereof include PVA-105, PVA-110, PVA-117, PVA-117H, PVA-120, PVA-124, PVA-124H, PVA-CS, PVA-CST, PVA-HC, PVA-203, PVA-204, PVA-205, PVA-210, PVA-217, PVA-220, PVA-224, PVA-217EE, PVA-217E, PVA-220E, PVA-224E, PVA-405, PVA-420, PVA-613 and L-8 (produced by Kuraray Co., Ltd.). The polyvinyl alcohols can be used individually or as a mixture. The content of polyvinyl alcohol in the protective layer is preferably from 20 to 95% by mass, and more preferably from 30 to 90% by mass.

Also, known modified polyvinyl alcohol can be preferably used. Particularly, an acid-modified polyvinyl alcohol having a carboxylic acid group or a sulfonic acid group is preferably used.

As a component used as a mixture with polyvinyl alcohol, polyvinyl pyrrolidone or a modified product thereof is preferred from the viewpoint of the oxygen-blocking property and removability by development. The content thereof is ordinarily from 3.5 to 80% by mass, preferably from 10 to 60% by mass, more preferably from 15 to 30% by mass, in the protective layer.

As other component of the protective layer, glycerin, dipropylene glycol or the like can be added in an amount corresponding to several % by mass of the water-soluble polymer compound to provide flexibility. Further, an anionic surfactant, for example, sodium alkylsulfate or sodium alkylsulfonate, an amphoteric surfactant, for example, alkylaminocarboxylate and alkylaminodicarboxylate, or a nonionic surfactant, for example, polyoxyethylene alkyl phenyl ether can be added in an amount corresponding to several % by mass of the water-soluble polymer compound.

Further, it is also preferred to incorporate an inorganic stratiform compound described in Paragraph Nos. [0018] to [0024] of JP-A-2006-106700 into the protective layer of the lithographic printing plate precursor according to the invention for the purpose of improving the oxygen-blocking property and property for protecting the surface of photosensitive layer. Of the inorganic stratiform compounds, fluorine based swellable synthetic mica, which is a synthetic inorganic stratiform compound, is particularly useful.

The coating amount of the protective layer is preferably in a range of 0.05 to 10 g/m² in terms of the coating amount after drying. When the protective layer contains the inorganic stratiform compound, it is more preferably in a range of 0.1 to 5 g/m², and when the protective layer does not contain the inorganic stratiform compound, it is more preferably in a range of 0.5 to 5 g/m².

### [Support]

A support for use in the lithographic printing plate precursor according to the invention is not particularly restricted as long as it is a dimensionally stable plate-like hydrophilic support. Particularly, an aluminum plate is preferred. In advance of the use of an aluminum plate, the aluminum plate is preferably subjected to a surface treatment, for example, roughening treatment or anodizing treatment. The roughening treatment of the surface of the aluminum plate is conducted by various methods and includes, for example, mechanical roughening treatment, electrochemical roughening treatment (roughening treatment of electrochemically dissolving the surface) and chemical roughening treatment (roughening treatment of chemically dissolving the surface selectively). With respect to the treatments, methods described in Paragraph Nos. [0241] to [0245] of JP-A-2007-206217 are preferably used.

The center line average roughness of the support is preferably from 0.10 to 1.2 µm. In the range described above, good adhesion property to the photosensitive layer, good printing durability and good resistance to stain are achieved.

The color density of the support is preferably from 0.15 to 0.65 in terms of the reflection density value. In the range described above, good image-forming property by preventing halation at the image exposure and good aptitude for plate inspection after development are achieved.

The thickness of the support is preferably from 0.1 to 0.6 mm, more preferably from 0.15 to 0.4 mm, and still more preferably from 0.2 to 0.3 mm.

### <Hydrophilizing treatment of support and undercoat layer>

In the lithographic printing plate precursor according to the invention, in order to increase hydrophilicity of the non-image area and to prevent printing stain, it is preferred to conduct hydrophilizing treatment of the surface of support or to provide an undercoat layer between the support and the photosensitive layer.

The hydrophilizing treatment of the surface of support includes an alkali metal silicate treatment wherein the support is subjected to an immersion treatment or an electrolytic treatment in an aqueous solution, for example, of sodium silicate, a method of treating with potassium fluorozirconate and a method of treating with polyvinylphosphonic acid. An immersion treatment in an aqueous polyvinylphosphonic acid solution is preferably used.

As the undercoat layer, an undercoat layer containing a compound having an acid group, for example, a phosphonic acid group, a phosphoric acid group or a sulfonic acid group is preferably used. It is preferred that the compound further has a polymerizable group in order to increase the adhesion property to the photosensitive layer. Also, a compound further having a hydrophilicity-imparting group, for example, an ethylene oxide group is exemplified as a preferable compound.

These compounds may be low molecular weight compounds or polymer compounds. For example, a silane coupling agent having an addition-polymerizable ethylenic double bond reactive group described in JP-A-10-282679 and a phosphorus-containing compound having an ethylenic double bond reactive group described in JP-A-2-304441 are preferably exemplified.

As the particularly preferable undercoat layer, an undercoat layer containing a low molecular weight compound or polymer compound having a crosslinkable group (preferably an ethylenically unsaturated bond group), a functional group capable of interacting with the surface of support and a hydrophilic group described in JP-A-2005-238816, JP-A-2005-125749, JP-A-2006-239867 and JP-A-2006-215263 is exemplified.

The coating amount (solid content) of the undercoat layer is preferably from 0.1 to 100 mg/m², and more preferably from 1 to 30 mg/m².

### <Backcoat layer>

The lithographic printing plate precursor according to the invention may have a backcoat layer provided on the back surface of the support, if desired. The backcoat layer preferably includes, for example, a coating layer comprising an organic polymer compound described in JP-A-5-45885 and a coating layer comprising a metal oxide obtained by hydrolysis and polycondensation of an organic metal compound or inorganic metal compound described in JP-A-6-35174. Among them, a layer using an alkoxy compound of silicon, for example, Si(OCH₃)₄, Si(OC₂H₅)₄, Si(OC₃H₇)₄ or Si(OC₄H₉)₄ is preferred since the starting materials are inexpensive and easily available.

### [Method of preparing lithographic printing plate]

The method of preparing a lithographic printing plate according to the invention comprises exposing with laser the lithographic printing plate precursor according to the invention, and without undergoing a water washing step, removing the protective layer and an unexposed area of the photosensitive layer in the presence of a developer containing the compound represented by formula (1) and the compound represented by formula (2), and thereafter not conducting a water washing step.

### [Laser exposure]

The lithographic printing plate precursor according to the invention is imagewise exposed with laser through a transparent original having a line image, a halftone dot image or the like, or imagewise exposed, for example, by scanning of laser beam based on digital data, in a conventional manner.

The wavelength of the exposure light source is preferably from 300 to 450 nm or from 750 to 1,400 nm. The light source of 300 to 450 nm is applied to the lithographic printing plate precursor having a photosensitive layer containing a sensitizing dye having an absorption maximum in such a wavelength range. The light source of 750 to 1,400 nm is applied to the lithographic printing plate precursor containing an infrared absorbing agent which is a sensitizing dye having an absorption maximum in such a wavelength range. As the light source of 300 to 450 nm, a semiconductor laser is preferably used. As the light source of 750 to 1,400 nm, a solid laser or semiconductor laser emitting an infrared ray is preferably used. The exposure mechanism may be any of an internal drum system, an external drum system and a flat bed system.

### [Development processing]

In the method of preparing a lithographic printing plate according to the invention, the exposed lithographic printing plate precursor is processed with the developer according to the invention without undergoing a water washing step. By the processing with the developer, the protective layer and the unexposed area of the photosensitive layer are removed (developed). Then, without undergoing a water washing step, drying is conducted, if desired, to prepare a lithographic printing plate. After the development processing, it is preferred that the excess developer is removed using a squeeze roller, followed by conducting drying. The drying can be conducted, for example, using hot air, an infrared ray or a far-infrared ray. The method of preparing a lithographic printing plate according to the invention is characterized in that the lithographic printing plate is prepared without undergoing a water washing step not only before the development processing but also after the development processing. Specifically, the method according to the invention can provide a lithographic printing plate without undergoing a water washing step between the development processing and a printing step. The printing step means a step starting with mounting of the lithographic printing plate prepared on a printing machine for printing.

As described hereinafter, when the developer contains a water-soluble polymer compound, the development and gum solution treatment can be simultaneously conducted. Specifically, the method according to the invention enables one solution processing or one bath processing.

Therefore, the method of preparing a lithographic printing plate according to the invention has the advantage of reduction of running cost and space saving in addition to the advantage in the environment due to reduction in disposal of waste liquid.

The development processing according to the invention is performed in a conventional manner at temperature ordinarily from 0 to 60°C, preferably from about 15 to about 40°C, using, for example, a method wherein the exposed lithographic printing plate precursor is immersed in the developer and rubbed with a brush or a method wherein the developer is sprayed to the exposed lithographic printing plate precursor and the exposed lithographic printing plate precursor is rubbed with a brush.

The development processing according to the invention can be preferably performed by an automatic developing machine equipped with a supplying means for the developer and a rubbing member. An automatic developing machine using a rotating brush roll as the rubbing member is particularly preferred. The automatic developing machine is preferably provided with a means for removing the excess developer, for example, a squeeze roller, or a drying means, for example, a hot air apparatus, subsequently to the development processing means.

An example of the structure of automatic developing machine suitably used in the method of preparing a lithographic printing plate according to the invention is schematically shown in Fig. 1. The automatic developing machine shown in Fig. 1 comprises basically a developing unit 6 and a drying unit 10. A lithographic printing plate precursor 4 is subjected to development in a developing bath 20 and dried in the drying unit 10.

In the case of conducting development using an automatic developing machine, the developer becomes fatigued in accordance with the processing amount, and hence the processing ability may be restored using a replenisher or a fresh developer.

### (Developer)

The developer is characterized by containing the compound represented by formula (1) shown below, which is an aromatic ether type nonionic surfactant, and the compound represented by formula (2) shown below, which is an aliphatic ether type nonionic surfactant:

X-Y-O-(A1)ₙ₁-(B1)ₘ₁-H (1)

wherein, in formula (1), X represents an aromatic group, Y represents a single bond or an alkylene group having from 1 to 10 carbon atoms, A1 and B1, which are different from each other, each represents -CH₂CH₂O- or -CH₂CH(CH₃)O-, and n1 and m1 each represents an integer of 0 to 100, provided that a sum total of n1 and m1 is from 12 to 28;

Z-L-(A2)ₙ₂-(B2)ₘ₂-H (2)

wherein, in formula (2), Z represents an alkyl group having from 1 to 20 carbon atoms, L represents -O- or -COO-, A2 and B2, which are different from each other, each represents -CH₂CH₂O- or -CH₂CH(CH₃)O-, and n2 and m2 each represents an integer of 0 to 100, provided that a sum total of n2 and m2 is from 12 to 28.

In formula (1), the aromatic group represented by X preferably includes a phenyl group, a naphthyl group or an anthryl group. The aromatic group may have a substituent. The substituent includes an organic group having from 1 to 100 carbon atoms. In formula (1), when both A1 and B1 are present, they may be present in random or in a block form.

Specific examples of the organic group having from 1 to 100 carbon atoms include a saturated or unsaturated, straight-chain or branched aliphatic hydrocarbon group or an aromatic hydrocarbon group (for example, an alkyl group, an alkenyl group, an alkynyl group, an aryl group or an aralkyl group), an alkoxy group, an aryloxy group, an N-alkylamino group, an N,N-dialkylamino group, an N-arylamino group, an N,N-diarylamino group, an N-alkyl-N-arylamino group, an acyloxy group, a carbamoyloxy group, an N-alkylcarbamoyloxy group, an N-arylcarbamoyloxy group, an N,N-dialkylcarbamoyloxy group, an N,N-diarylcarbamoyloxy group, an N-alkyl-N-arylcarbamoyloxy group, an acylamino group, an N-alkylacylamino group, an N-arylacylamino group, an acyl group, an alkoxycarbonylamino group, an alkoxycarbonyl group, an aryloxycarbonyl group, a carbamoyl group, an N-alkylcarbamoyl group, an N,N-dialkylcarbamoyl group, an N-arylcarbamoyl group, an N,N-diarylcarbamoyl group, an N-alkyl-N-arylcarbamoyl group, a polyoxyalkylene chain, and the above-described organic groups to which a polyoxyalkylene chain is connected. The alkyl group described above may be a straight-chain or branched alkyl group.

Of the compounds represented by formula (1), compounds represented by formulae (1-A) and (1-B) shown below are preferred.

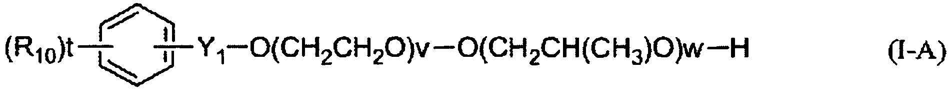

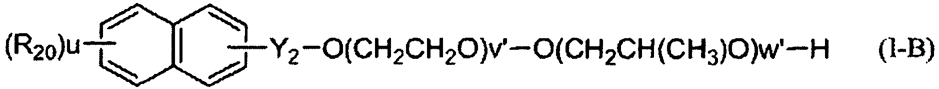

In formulae (1-A) and (1-B), R₁₀ and R₂₀ each represents a hydrogen atom or an organic group having from 1 to 100 carbon atoms, t and u each represents 1 or 2, Y₁ and Y₂ each represents a single bond or an alkylene group having from 1 to 10 carbon atoms, v and w each represents an integer of 0 to 100, provided that a sum total of v and w is from 12 to 28, and v' and w' each represents an integer of 0 to 100, provided that a sum total of v' and w' is from 12 to 28.

When t is 2 and R₁₀ represents an organic group having from 1 to 100 carbon atoms, two R₁₀ may be the same or different, or may be combined with each other to from a ring. Also, when u is 2 and R₂₀ represents an organic group having from 1 to 100 carbon atoms, two R₂₀ may be the same or different, or may be combined with each other to from a ring.

Specific examples of the organic group having from 1 to 100 carbon atoms are same as those described in formula (1) above.

Preferable examples of R₁₀ and R₂₀ include a hydrogen atom, a straight-chain or branched alkyl group having from 1 to 10 carbon atoms, an alkoxy group having 10 or less carbon atoms, an alkoxycarbonyl group, an N-alkylamino group, an N,N-dialkylamino group, an N-alkylcarbamoyl group, an acyloxy group, an acylamino group, a polyoxyalkylene chain having a repeating unit number of about 5 to about 20, an aryl group having from 6 to 20 carbon atoms and an aryl group having a polyoxyalkylene chain having a repeating unit number of about 5 to about 20.

The compound represented by formula (1-A) includes, for example, polyoxyethylene phenyl ether, polyoxyethylene methylphenyl ether, polyoxyethylene octylphenyl ether and polyoxyethylene nonylphenyl ether.

The compound represented by formula (1-B) includes, for example, polyoxyethylene naphthyl ether, polyoxyethylene methylnaphthyl ether, polyoxyethylene octylnaphthyl ether and polyoxyethylene nonylnaphthyl ether.

The compounds represented by formulae (1) may be used individually or in combination of two or more thereof in the developer.

The content of the compound represented by formula (1) is preferably from 1 to 20% by mass, more preferably from 2 to 10% by mass, in the developer. When the content is in the range described above, the effects according to the invention are preferably achieved.

Specific examples of the compound represented by formula (1) are set forth below.

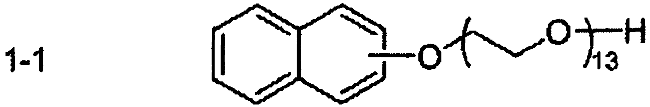

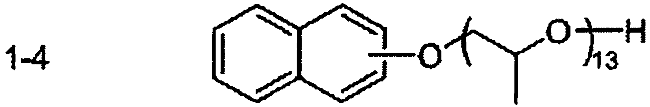

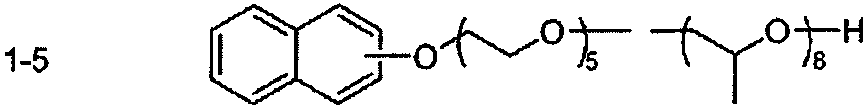

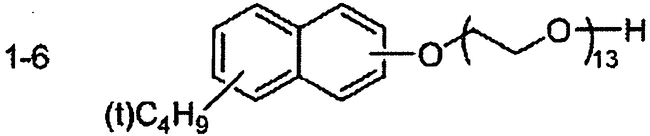

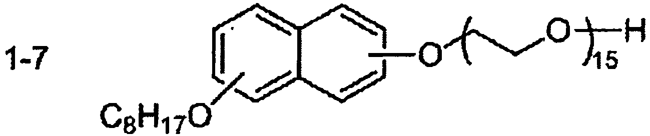

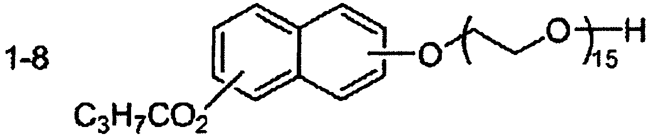

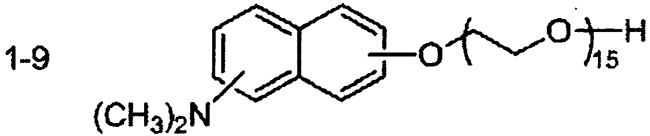

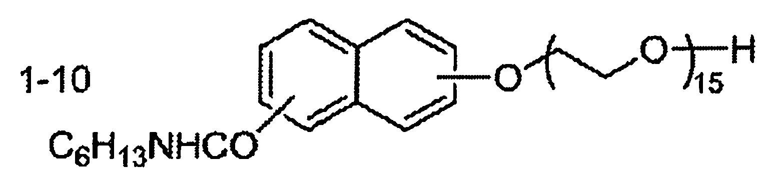

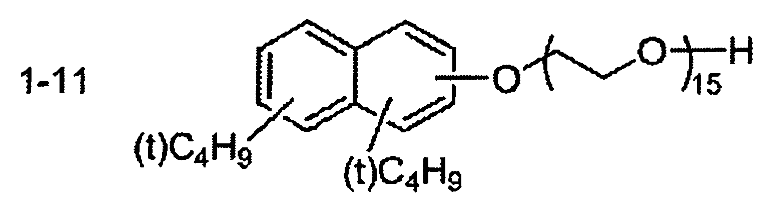

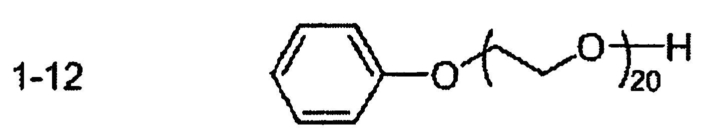

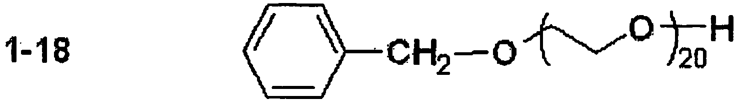

In the compound represented by formula (2), the alkyl group represented by Z may be a straight-chain or branched alkyl group and is preferably an alkyl group having from 4 to 18 carbon atoms. L is preferably -O-.

The compounds represented by formulae (2) may be used individually or in combination of two or more thereof in the developer.

The content of the compound represented by formula (2) is preferably from 1 to 20% by mass, more preferably from 2 to 10% by mass, in the developer. When the content is in the range described above, the effects according to the invention are preferably achieved.

Specific examples of the compound represented by formula (2) are set forth below.

2-1 C₄H₉O(CH₂CH₂O)₁₅H

2-7 C₈H₁₇O(CH₂CH₂O)₂₀H

2-8 C₁₆H₃₃O(CH₂CH₂O)₂₅H

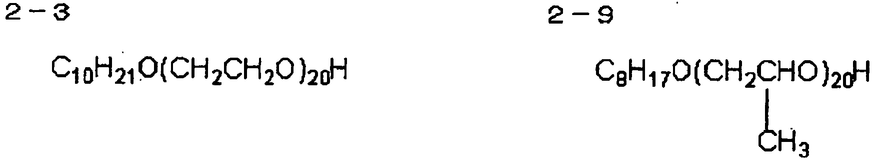

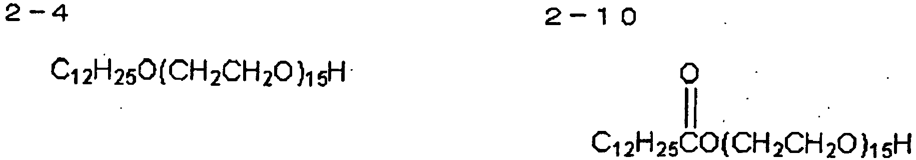

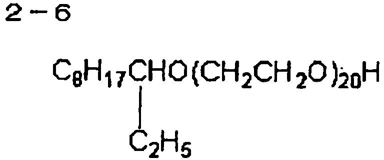

A mixing ratio of the compound represented by formula (1) to the compound represented by formula (2) is preferably from 0.1/99.9 to 99.9/0.1, more preferably from 0.5/99.5 to 99.5/0.5, and still more preferably from 1/99 to 99/1.

The compounds represented by formulae (1) and (2) are ordinarily available in the market. Examples of the commercial product include those produced, for example, by Kao Corp., Sanyo Chemical Industries, Ltd., Nippon Nyukazai Co., Ltd. or Takemoto Oil & Fat Co., Ltd.

The developer for use in the invention may contain a surfactant (for example, an anionic, nonionic, cationic or amphoteric surfactant) other than the compounds represented by formulae (1) and (2). Of the surfactants, a nonionic surfactant and an amphoteric surfactant are preferred, and a nonionic surfactant is more preferred.

Examples of the nonionic surfactant include a polyoxyethylene alkyl ether, a polyoxyethylene alkylphenyl ether, polyoxyethylene polystyrylphenyl ether, glycerin fatty acid partial ester, a sorbitan fatty acid partial ester, a pentaerythritol fatty acid partial ester, a propylene glycol fatty acid monoester, a sucrose fatty acid partial ester, a polyoxyethylenesorbitan fatty acid partial ester, a polyoxyethylenesorbitol fatty acid partial ester, a polyethylene glycol fatty acid ester, a polyglycerin fatty acid partial ester, a polyoxyethyleneglycerin fatty acid partial ester, a polyoxyethylene diglycerin, a fatty acid diethanolamide, an N,N-bis-2-hydroxyalkylamine, a polyoxyethylene alkylamine, a triethanolamine fatty acid ester, a trialkylamine oxide, a polyoxyethylene alkylphenyl ether and a polyoxyethylene-polyoxypropylene block copolymer.

Further, an acetylene glycol-based or acetylene alcohol-based oxyethylene adduct, a fluorine-based or silicon-based anionic or nonionic surfactant can also be used. The total amount of the surfactant other than the compounds represented by formulae (1) and (2) is not particularly restricted and is preferably from 0.01 to 20% by mass, more preferably from 0.1 to 15% by mass, still more preferably from 1 to 10% by mass, based on the total weight of the developer.

The developer for use in the invention is preferably an aqueous solution containing the compounds represented by formulae (1) and (2) and containing water as a main component (containing 60% by mass or more of water). The pH of the developer is preferably from 2 to 11, more preferably from 3 to 10.7, still more preferably from 4 to 10.5, and most preferably from 6 to 10.

The developer according to the invention preferably contains an organic solvent. As the organic solvent to be incorporated, for example, a polar solvent, an aliphatic hydrocarbon (e.g., hexane, heptane, Isopar E, Isopar H or Isopar G (produced by Esso Chemical Co., Ltd.)), an aromatic hydrocarbon (e.g., toluene or xylene), or a halogenated hydrocarbon (methylene dichloride, ethylene dichloride, trichlene or monochlorobenzene) is exemplified.

Examples of the polar solvent include an alcohol (e.g., methanol, ethanol, propanol, isopropanol, octanol, benzyl alcohol, ethylene glycol monomethyl ether, 2-ethyoxyethanol, diethylene glycol monoethyl ether, diethylene glycol monohexyl ether, triethylene glycol monomethyl ether, propylene glycol monoethyl ether, propylene glycol monomethyl ether, polyethylene glycol monomethyl ether, polypropylene glycol, tetraethylene glycol, ethylene glycol monobutyl ether, ethylene glycol monobenzyl ether, ethylene glycol monophenyl ether, propylene glycol monophenyl ether, methyl phenyl carbinol, n-amyl alcohol or methylamyl alcohol), a ketone (e.g., acetone, methyl ethyl ketone, ethyl butyl ketone, methyl isobutyl ketone or cyclohexanone), an ester (e.g., ethyl acetate, propyl acetate, butyl acetate, amyl acetate, benzyl acetate, methyl lactate, butyl lactate, ethylene glycol monobutyl acetate, polyethylene glycol monomethyl ether acetate, diethylene glycol acetate, diethyl phthalate or butyl levulinate) and others (e.g., triethyl phosphate, tricresyl phosphate, N-phenylethanolamine or N-phenyldiethanolamine).

When the organic solvent is insoluble in water, it may be employed by being solubilized in water using a surfactant or the like. In the case where the developer contains an organic solvent, the concentration of the organic solvent is desirably less than 40% by mass in view of safety and inflammability.

The developer for use in the invention preferably contains a pH buffer agent. As the pH buffer agent, a pH buffer agent exhibiting a pH buffer function at pH of 2 to 11 is used without particular restriction. In the invention, a weak alkaline buffer agent is preferably used and includes, for example, (a) a carbonate ion and a hydrogen carbonate ion, (b) a borate ion, (c) a water-soluble amine compound and an ammonium ion thereof, and combinations thereof. Specifically, for example, (a) a combination of a carbonate ion and a hydrogen carbonate ion, (b) a borate ion, or (c) a combination of a water-soluble amine compound and an ammonium ion thereof exhibits a pH buffer function in the developer to prevent fluctuation of the pH even when the developer is used for a long period of time, whereby the effect of preventing, for example, the deterioration of developing property resulting from the fluctuation of pH or the occurrence of development scum is achieved. The combination of a carbonate ion and a hydrogen carbonate ion or the combination of a water-soluble amine compound and an ammonium ion thereof is particularly preferred.

In order for a carbonate ion and a hydrogen carbonate ion to be present in the developer, a carbonate and a hydrogen carbonate may be added to the developer or a carbonate ion and a hydrogen carbonate ion may be generated by adding a carbonate or a hydrogen carbonate to the developer and then adjusting the pH. The carbonate or hydrogen carbonate used is not particularly restricted and it is preferably an alkali metal salt thereof. Examples of the alkali metal include lithium, sodium and potassium and sodium is particularly preferred. The alkali metals may be used individually or in combination of two or more thereof.

When the combination (a) of a carbonate ion and a hydrogen carbonate ion is adopted as the pH buffer agent, the total amount of the carbonate ion and hydrogen carbonate ion is preferably from 0.05 to 5 mol/l, more preferably from 0.1 to 2 mol/l, particularly preferably from 0.2 to 1 mol/l, in the developer.

The water-soluble amine compound is not particularly restricted and preferably a water-soluble amine having a group capable of accelerating water-solubility. Preferable examples of the water-soluble amine compound include monoethanolamine, diethanolamine, triethanolamine, N-hydroxyethylmorpholine, glycine, iminodiacetic acid, alanine and taurine. The amount of the water-soluble amine compound is preferably from 0.01 to 10% by mass, more preferably from 0.01 to 8% by mass, particularly preferably from 0.05 to 5% by mass, in the developer.

By incorporating a water-soluble polymer compound into the developer for use in the invention, the development and gum solution treatment are possible to conduct in one solution. The water-soluble polymer compound for use in the developer according to the invention includes, for example, soybean polysaccharide, modified starch, gum arabic, dextrin, a cellulose derivative (for example, carboxymethyl cellulose, carboxyethyl cellulose or methyl cellulose) or a modified product thereof, pllulan, polyvinyl alcohol or a derivative thereof, polyvinyl pyrrolidone, polyacrylamide, an acrylamide copolymer, a vinyl methyl ether/maleic anhydride copolymer, a vinyl acetate/maleic anhydride copolymer and a styrene/maleic anhydride copolymer.

As the soybean polysaccharide, known soybean polysaccharide can be used. For example, as a commercial product, SOYAFIVE (trade name, produced by Fuji Oil Co., Ltd.) is available and various grade products can be used. The soybean polysaccharide preferably used is that having viscosity in a range of 10 to 100 mPa/sec in the 10% by mass aqueous solution thereof.

As the modified starch, known modified starch can be used. The modified starch can be prepared, for example, by a method wherein starch, for example, of corn, potato, tapioca, rice or wheat is decomposed, for example, with an acid or an enzyme to an extent that the number of glucose residue per molecule is from 5 to 30 and then oxypropylene is added thereto in an alkali.

Two or more kinds of the water-soluble polymer compounds may be used in combination. The content of the water-soluble polymer compound in the developer is preferably from 0.1 to 20% by mass, and more preferably from 0.5 to 10% by mass.

The developer according to the invention may further contain a preservative, a chelating agent, a defoaming agent, an organic acid, an inorganic acid, an inorganic salt or the like. Specifically, compounds described in Paragraph Nos. [0266] to [0270] of JP-A-2007-206217 are preferably used.

The developer described above can be used as a developer or a development replenisher for the lithographic printing plate precursor and is preferably applied to the automatic processing machine as described above.

In the method of preparing a lithographic printing plate using the lithographic printing plate precursor according to the invention, the entire surface of the lithographic printing plate precursor may be heated before the exposure, during the exposure or between the exposure and the development, if desired. By the heating, the image-forming reaction in the photosensitive layer is accelerated and advantages, for example, improvement in the sensitivity and printing durability and stabilization of the sensitivity may be achieved. For the purpose of increasing the image strength and printing durability, it is also effective to perform entire after-heating or entire exposure of the image after the development. Ordinarily, the heating before the development is preferably performed under a mild condition of 150°C or lower. When the temperature is too high, a problem may arise sometimes in that the unexposed area is also cured. On the other hand, the heating after the development can be performed using very strong conditions. Ordinarily, the heat treatment is carried out in a temperature range of 100 to 500°C. When the temperature is too low, the sufficient effect of strengthening the image may not be obtained, whereas when it is excessively high, problems of deterioration of the support and thermal decomposition of the image area may occur sometimes.

### [Examples]

The present invention will be described in more detail with reference to the following examples, but the invention should not be construed as being limited thereto.

### Examples 1 to 36 and Comparative Examples 1 to 14

### [Preparation of Lithographic printing plate precursor 1]

### (Preparation of Support 1)

An aluminum plate (JIS A1050) having a thickness of 0.3 mm was subjected to surface treatment according to the steps shown below.

### (a) Alkali etching treatment

Alkali etching treatment of the aluminum plate was conducted by spraying an aqueous solution having sodium hydroxide concentration of 26% by mass, aluminum ion concentration of 6.5% by mass and temperature of 70°C to dissolve the aluminum plate in an amount of 10 g/m², followed by washing with water by spraying.

### (b) Desmut treatment

Desmut treatment of the aluminum plate was conducted by spraying an aqueous nitric acid solution having temperature of 30°C, followed by washing with water by spraying. The aqueous nitric acid solution used in the desmut treatment was a waste solution from a step of electrochemical surface roughening treatment using alternating current in an aqueous nitric acid solution.

### (c) Electrochemical surface roughening treatment

Electrochemical surface roughening treatment of the aluminum plate was continuously conducted by applying 60 Hz alternating current voltage. The electrolytic solution used was an aqueous solution containing 10.5 g/liter of nitric acid (containing 5 g/liter of aluminum ion and 0.007% by mass of ammonium ion) and the solution temperature was 50°C. The electrochemical surface roughening treatment was conducted using a trapezoidal rectangular wave alternating current where time (TP) for reaching the current to its peak from zero was 0.8 msec and a duty ratio was 1:1, and using a carbon electrode as a counter electrode. A ferrite was used as an auxiliary anode. The electrolytic cell used was a radial cell type. The current density was 30 A/dm² at the peak current, and the electric quantity was 220 C/dm² in terms of the total electric quantity during the aluminum plate functioning as an anode. To the auxiliary anode, 5% of the current from the electric source was divided. Subsequently, the aluminum plate was washed with water by spraying.

### (d) Alkali etching treatment

Alkali etching treatment of the aluminum plate was conducted by spraying an aqueous solution having sodium hydroxide concentration of 5% by mass, aluminum ion concentration of 0.5% by mass and temperature of 50°C, followed by washing with water by spraying.

### (e) Desmut treatment

Desmut treatment of the aluminum plate was conducted at 35°C for 4 seconds. As an aqueous sulfuric acid solution for the desmut treatment, a waste solution generated in a step of anodizing treatment was used.

### (f) Anodizing treatment

Anodizing treatment of the aluminum plate was conducted using an anodizing treatment apparatus according to a two-stage feeding electrolytic treatment method (lengths of a first electrolytic unit and a second electrolytic unit: 6 m each; lengths of a first feeding unit and a second feeding unit: 3 m each; lengths of a first feeding electrode unit and a second feeding electrode unit: 2.4 m each). As an electrolytic solution supplied to the first electrolytic unit and second electrolytic unit, sulfuric acid was used. The electrolytic solution was an aqueous solution having sulfuric acid concentration of 50 g/liter (containing 0.5% by mass of aluminum ion) and the solution temperature was 20°C. Subsequently, the aluminum plate was washed with water by spraying. The amount of the final anodic oxide film was 2.7 g/m².

### (g) Treatment with polyvinylphosphonic acid

The aluminum plate was immersed in an aqueous solution containing 4 g/liter of polyvinylphosphonic acid at 40°C for 10 seconds, washed with demineralized water having calcium ion concentration of 75 ppm at 20°C (washing time: 4 sec) and then with pure water at 20°C (washing time: 4 sec) and dried. The adhesion amount of calcium ion was 1.92 g/m².

The center line average roughness (Ra indication according to JIS B0601) of Support 1 thus prepared was measured using a stylus having a diameter of 2 µm and found to be 0.25 µm.

### (Formation of Photosensitive layer 1)

Coating solution 1 for photosensitive layer having the composition shown below was coated on Support 1 using a bar and dried by a hot air drying device at 100°C for one minute to form a photosensitive layer 1 having a dry coating amount of 1.4 g/m².

### <Coating solution 1 for photosensitive layer>

| | |
|---|---|
| Polymerizable Compound (M-1) shown below | 3.6 parts by mass |
| Binder Polymer (B-1) shown below (weight average molecular weight: 47,000) | 2.4 parts by mass |
| Sensitizing Dye (D-1) shown below | 0.32 parts by mass |
| Polymerization Initiator (I-1) shown below | 0.61 parts by mass |
| Chain Transfer Agent (S-2) shown below | 0.57 parts by mass |
| Polymerization inhibitor | 0.020 parts by mass |
| N-Nitrosophenylhydroxylamine aluminum salt | |
| Dispersion of ε-phthalocyanine | 0.71 parts by mass |
| (pigment: 15 parts by mass; dispersing agent (allyl | |
| methacrylate/methacrylic acid copolymer (weight | |
| average molecular weight: 60,000, copolymerization | |
| molar ratio: 83/17)): 10 parts by mass; cyclohexanone: | |
| 15 parts by mass) | |
| Fluorine-Based Surfactant (F-1) shown below (weight average molecular weight: 11,000) | 0.016 part by mass |
| Methyl ethyl ketone | 47 parts by mass |
| Propylene glycol monomethyl ether | 45 parts by mass |

The structures of Polymerizable Compound (M-1), Binder Polymer (B-1), Sensitizing Dye (D-1), Polymerization Initiator (I-1), Chain Transfer Agent (S-2) and Fluorine-Based Surfactant (F-1) used in Coating solution 1 for photosensitive layer are shown below, respectively.

### M-1

### Mixture of the following compounds:

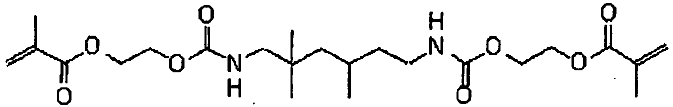

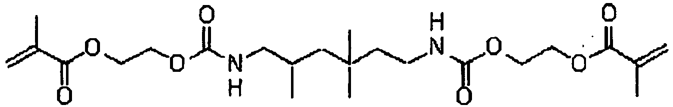

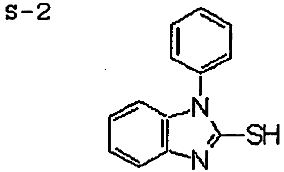

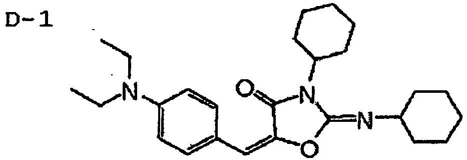

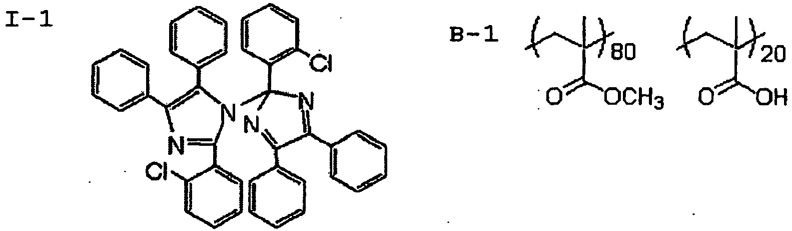

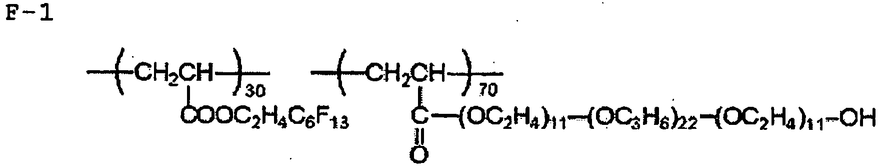

### (Formation of Protective layer 1)

Coating solution 1 for protective layer having the composition shown below was coated on Photosensitive layer 1 using a bar and dried by a hot air drying device at 125°C for 34 seconds to form Protective layer 1 having a dry coating amount of 1.8 g/m², thereby preparing Lithographic printing plate precursor 1.

### <Coating solution 1 for protective layer>

| | |
|---|---|
| Dispersion of mica shown below | 1.67 g |
| Sulfonic acid-modified polyvinyl alcohol (GOSERAN CKS-50, produced by Nippon Synthetic Chemical Industry Co., Ltd. (saponification degree: 99% by mole; average polymerization degree: 300; modification degree: about 0.4% by mole)] | 2.17 g |
| Surfactant (EMALEX 710, produced by Nihon Emulsion Co., Ltd.) | 0.16 g |
| Water | 43.6 g |

### <Dispersion of mica>

In 368 g of water was added 32 g of synthetic mica (SOMASIF ME-100, produced by CO-OP Chemical Co., Ltd.; aspect ratio: 1,000 or more) and the mixture was dispersed using a homogenizer until the average particle diameter (measured by a laser scattering method) became 0.5 µm to obtain dispersion of mica.

### [Preparation of Lithographic printing plate precursor 2]

### (Preparation of Support 2)

An aluminum plate (material: 1050, refining: H16) having a thickness of 0.24 mm was immersed in an aqueous 5% by mass sodium hydroxide solution maintained at 65°C to conduct a degreasing treatment for one minute, followed by washed with water. The degreased aluminum plate was immersed in an aqueous 10% by mass hydrochloric acid solution maintained at 25°C for one minute to neutralize, followed by washed with water. Subsequently, the aluminum plate was subjected to an electrolytic surface-roughening treatment with alternating current under condition of current density of 100 A/dm² in an aqueous 0.3% by mass hydrochloric acid solution at 25°C for 60 seconds and then subjected to a desmut treatment in an aqueous 5% by mass sodium hydroxide solution maintained at 60°C for 10 seconds. The aluminum plate thus-treated was subjected to an anodizing treatment under condition of current density of 10 A/dm² and voltage of 15 V in an aqueous 15% by mass sulfuric acid solution at 25°C for one minute and then subjected to a hydrophilization treatment using an aqueous 1% by mass polyvinylphosphonic acid solution at 75°C to prepare Support 2. The surface roughness of the support was measured and found to be 0.44 µm (Ra indication according to JIS B0601).

### (Formation of Photosensitive layer 2)

Coating solution 2 for photosensitive layer having the composition shown below was coated on Support 2 using a bar and dried in an oven at 90°C for 60 seconds to form Photosensitive layer 2 having a dry coating amount of 1.3 g/m².

### <Coating solution 2 for photosensitive layer>

| | |
|---|---|
| Binder Polymer (1) shown below (weight average molecular weight: 50,000) | 0.04 g |
| Binder Polymer (2) shown below (weight average molecular weight: 80,000) | 0.30 g |
| Polymerizable Compound (M-1) shown above | 0.17 g |
| Polymerizable Compound (M-2) shown below | 0.51 g |
| Sensitizing Dye (1) shown below | 0.03 g |
| Sensitizing Dye (2) shown below | 0.015 g |
| Sensitizing Dye (3) shown below | 0.015 g |
| Polymerization Initiator (I-1) shown above | 0.13 g |
| Chain Transfer Agent Mercaptobenzothiazole | 0.01 g |
| Dispersion of ε-phthalocyanine pigment (pigment: 15 parts by mass; dispersing agent (allyl methacrylate/methacrylic acid copolymer (weight average molecular weight: 60,000, copolymerization molar ratio: 83/17)): 10 parts by mass; cyclohexanone: 15 parts by mass) | 0.40 g |
| Thermal polymerization inhibitor | 0.01 g |
| N-nitrosophenylhydroxylamine aluminum salt | |
| Fluorine-Based Surfactant (F-1) shown above | 0.001 g |
| 1-Methoxy-2-propanol | 3.5 g |
| Methyl ethyl ketone | 8.0 g |

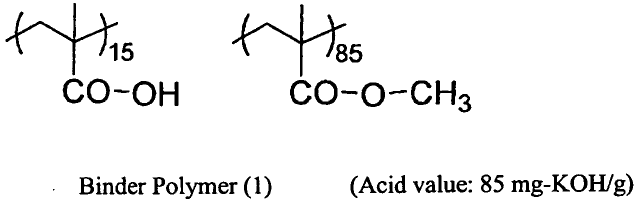

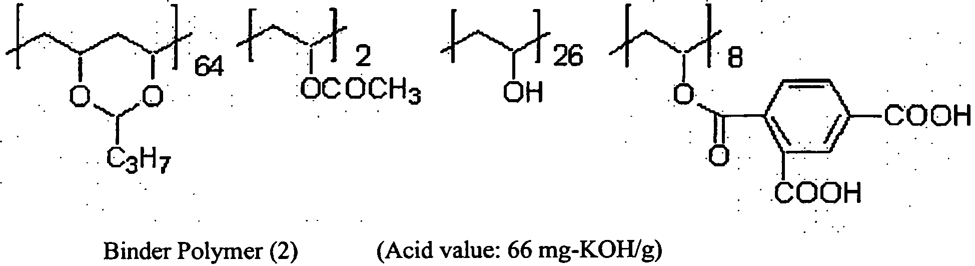

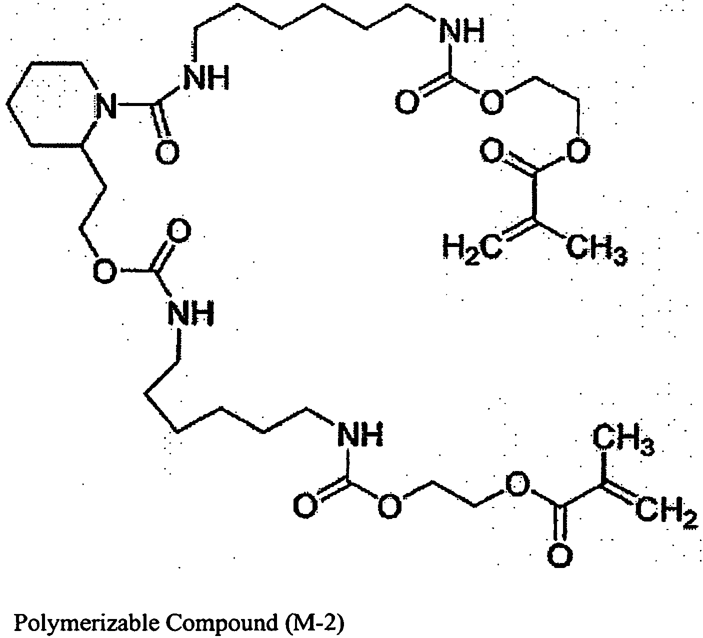

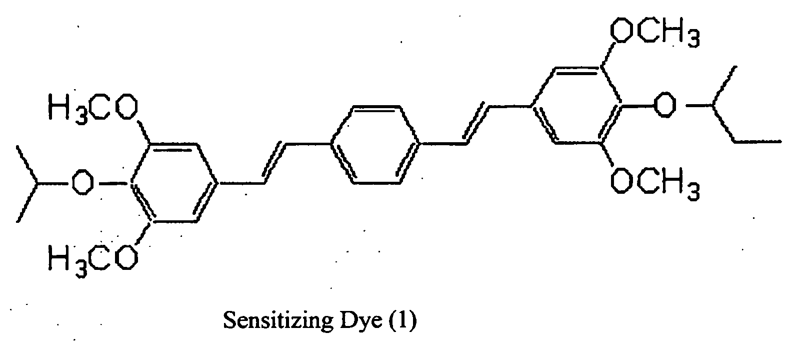

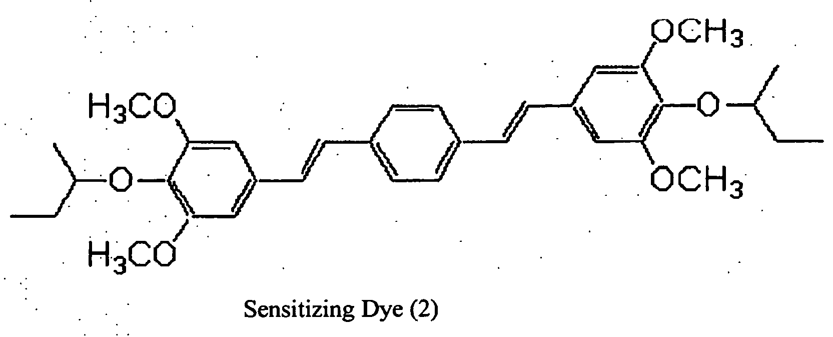

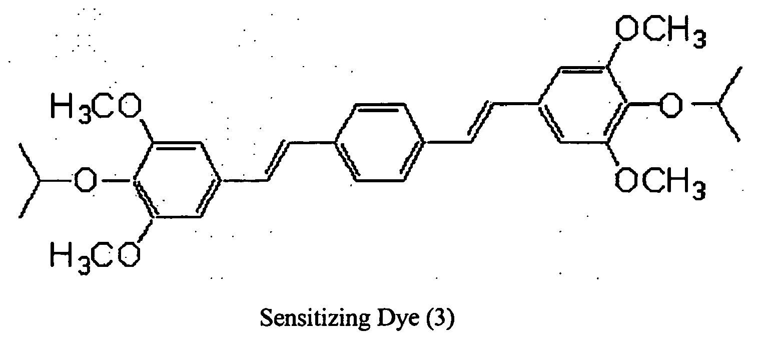

### (Formation of Protective layer 2)

Coating solution 2 for protective layer having the composition shown below was coated on Photosensitive layer 2 using a bar and dried at 125°C for 70 seconds to from Protective layer 2 having a dry coating amount of 1.2 g/m², thereby preparing Lithographic printing plate precursor 2.

### <Coating solution 2 for protective layer>

| | |
|---|---|
| PVA-205 [partially hydrolyzed polyvinyl alcohol, produced by Kuraray Co., Ltd. (saponification degree: 86.5 to 89.5% by mole; viscosity: 4.6 to 5.4 mPa·s in a 4% by mass aqueous solution at 20°C)] | 0.658 g |
| PVA-105 [fully hydrolyzed polyvinyl alcohol, produced by Kuraray Co., Ltd. (saponification degree: 98.0 to 99.0% by mole; viscosity: 5.2 to 6.0 mPa·s in a 4% by mass aqueous solution at 20°C)] | 0.142 g |
| Vinyl pyrrolidone/vinyl acetate (1/1) copolymer (weight average molecular weight: 70,000) | 0.001 g |
| Surfactant (EMALEX 710, produced by Nihon Emulsion Co., Ltd.) | 0.002 g |
| Water | 13 g |

### [Exposure, Development and Printing]

Each of the lithographic printing plate precursors was subjected to image exposure by a violet semiconductor laser plate setter Vx9600 (having InGaN semiconductor laser (emission wavelength: 405 mn ± 10 nm/output: 30 mW)) produced by FUJIFILM Electronic Imaging, Ltd. The image exposure was performed for 50% screen tint at resolution of 2,438 dpi using FM screen (TAFFETA 20, produced by FUJIFILM Corp.) in a plate surface exposure amount of 0.05 mJ/cm².

The exposed lithographic printing plate precursor was subjected to preheat at 100°C for 30 seconds and then subjected to development processing in an automatic developing machine having a structure as shown in Fig. 1 using each developer as shown in Table 1. The automatic developing machine had one brush roller having an outer diameter of 50 mm and being implanted with fiber of polybutylene terephthalate (bristle diameter: 200 µm, bristle length: 17 mm), and the brush roller was rotated at 200 rpm (peripheral velocity at the tip of brush: 0.52 m/sec) in the same direction as the transporting direction of the lithographic printing plate precursor. The temperature of the developer was 28°C. The transportation of the lithographic printing plate precursor was conducted at transporting speed of 100 cm/min. After the development processing, the lithographic printing plate was dried in a drying unit. The drying temperature was 80°C.

In Table 1, the amount of each component in the developer was indicated in grams. The control of pH of each developer was conducted with sodium hydroxide and phosphoric acid. The total amount of each developer was finally made one liter by adding ion-exchanged water.

Examples 6, 10-12, 15, 25, 29-31 and 34 fall outside the scope of the invention and are included for comparative purposes.

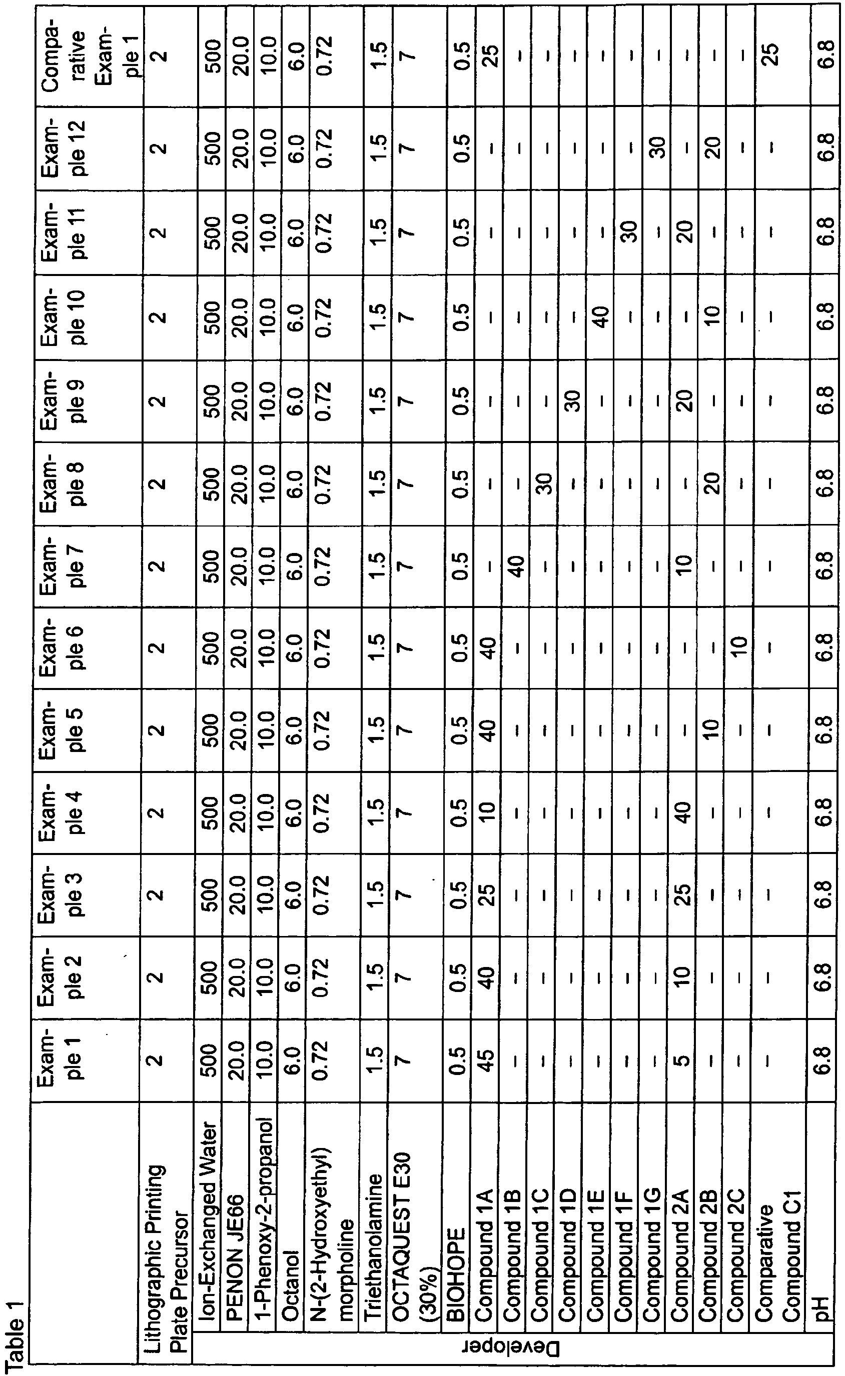

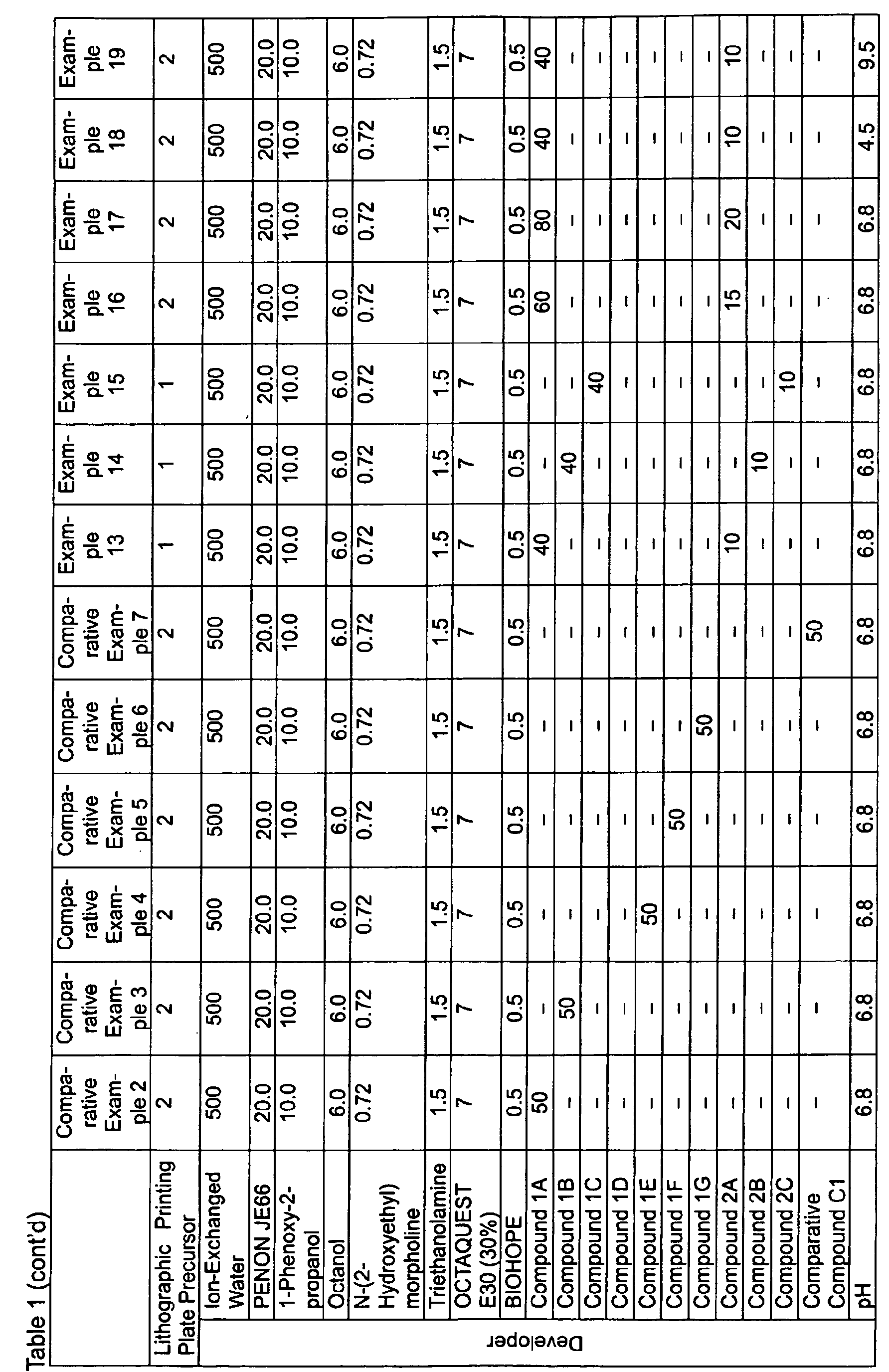

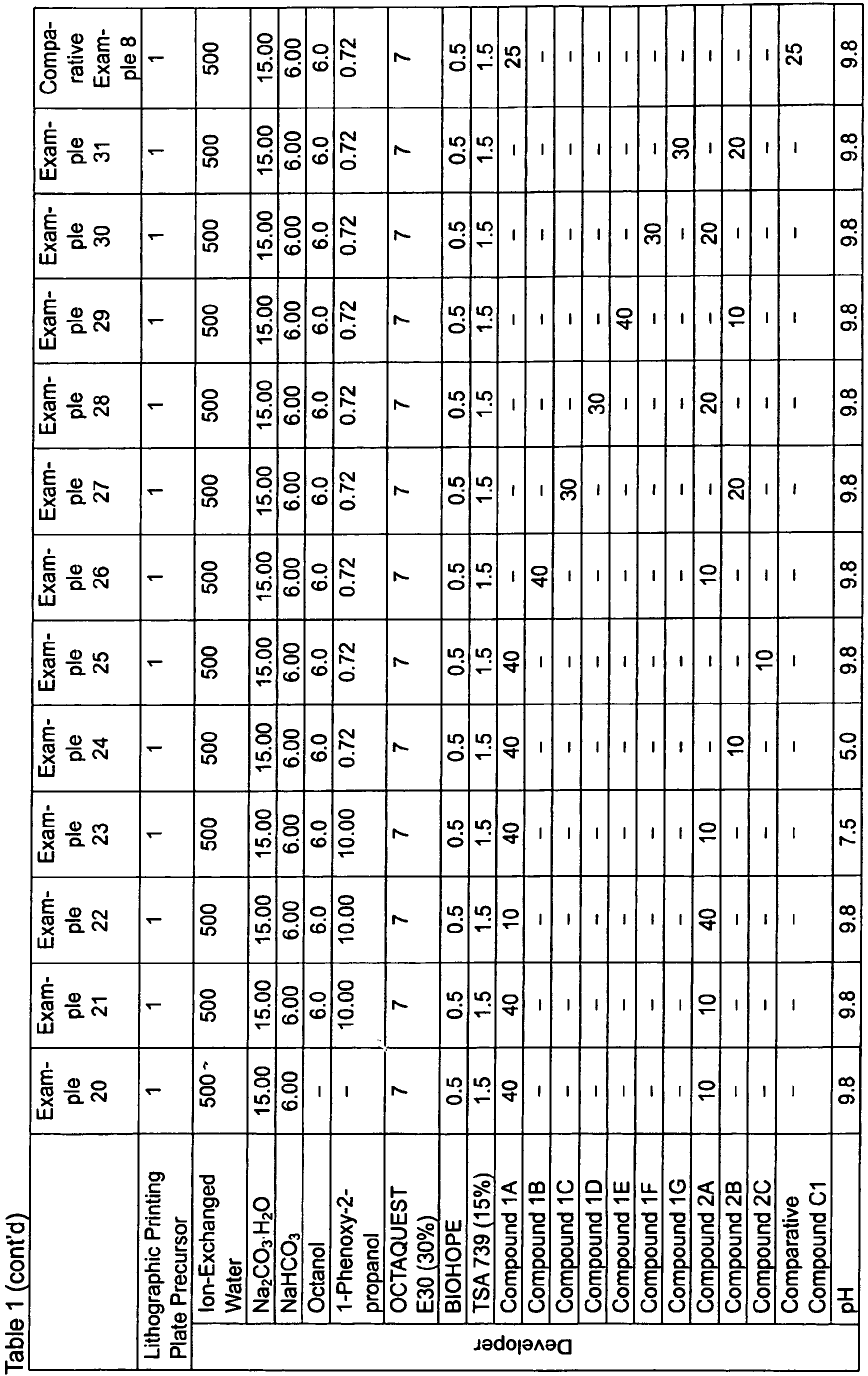

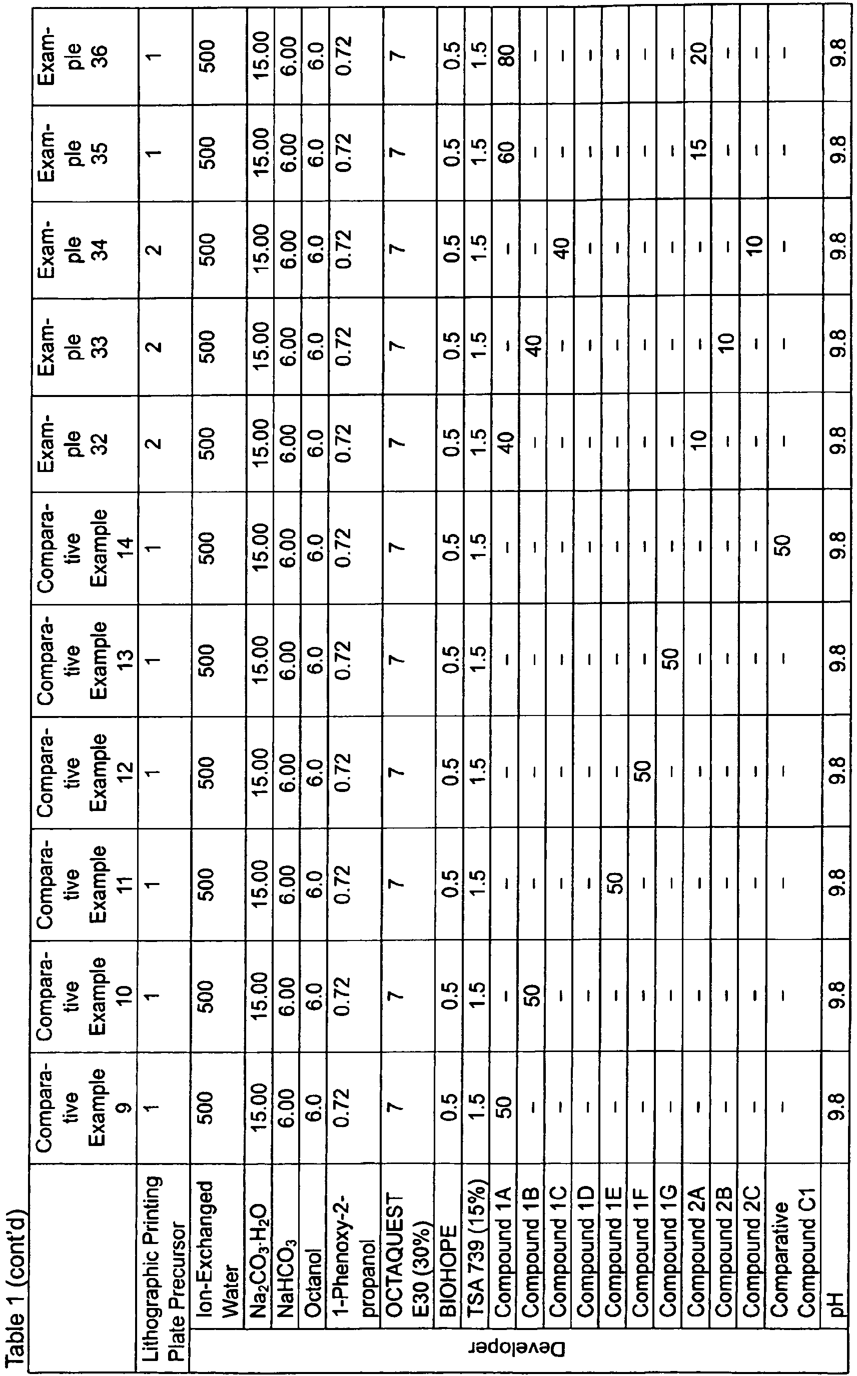

In the developers shown above, the components expressed using their trade names are described below.

PENON JE66: Hydroxypropylated starch, produced by Nippon Starch Chemical Co., Ltd. OCTAQUEST E30: Ethylenediaminedisuccinate, produced by Innospec Specialty Chemicals Inc.

BIOHOPE: Mixture of 2-bromo-2-nitropropane-1,3-diol, 2-methyl-4-isothiazolin-3-one and 5-chloro-2-methyl-4-isothiazolin-3-one, produced by K.I Chemical Industry Co., Ltd.

TSA 739: Silicone-based defoaming agent, produced by GE Toshiba Silicones Co., Ltd.)

Also, the structural formulae of Compounds 1A to 1G, Compounds 2A to 2C and Comparative Compound C1 are described below.

Compounds 1E, 1F and 1G fall outside formula (1), and compound 2C falls outside formula (2).

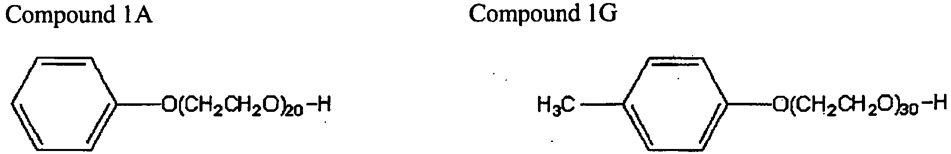

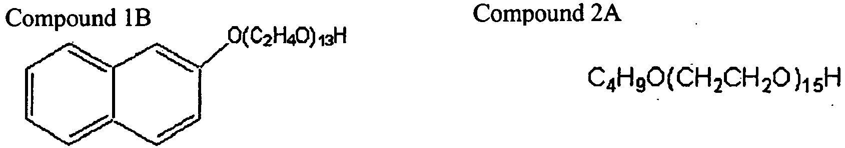

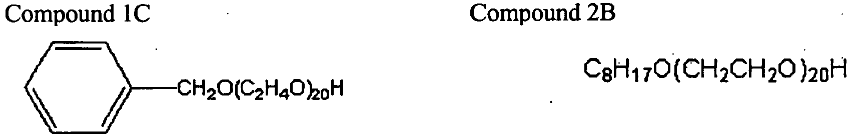

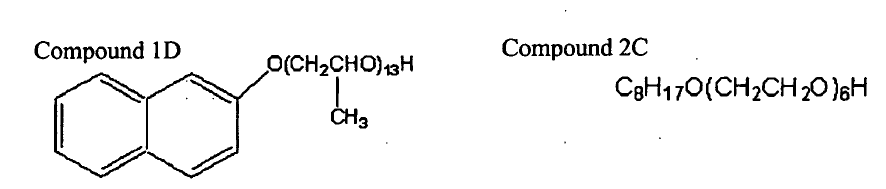

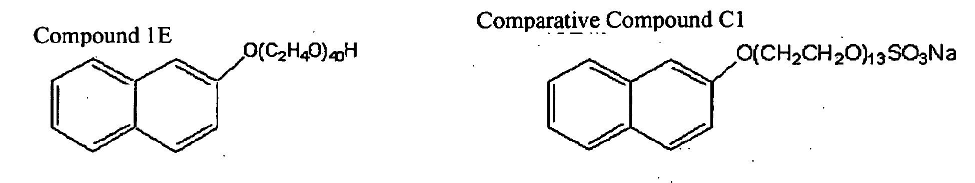

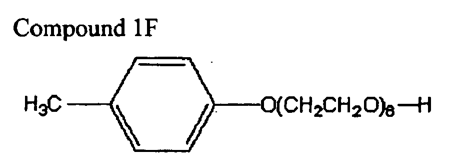

The lithographic printing plate obtained was mounted on a printing machine (SOR-M, produced by Heidelberg) and printing was performed at a printing speed of 6,000 sheets per hour using dampening water (EU-3 (etching solution, produced by FUJIFILM Corp.))/water/isopropyl alcohol = 1/89/10 (by volume ratio)) and TRANS-G (N) black ink (produced by Dainippon Ink & Chemicals, Inc.).

### [Evaluation]

The processing property, stain resistance, printing durability and solubility and preservation stability of the developer were evaluated in the manner described below. The results obtained are shown in Table 2.

### <Processing property>

After the lithographic printing plate precursor was subjected to development processing in the automatic developing machine under the condition described above in an amount of 500 m² spending one week, the occurrence of scum adhered on the tank wall of the automatic developing machine was visually observed. The scum occurred was mainly caused by the binder of the protective layer. The evaluation was conducted according to the following criteria:
A: Case where the occurrence of scum was not observed.
AB: Case where the occurrence of scum was slightly observed.
B: Case where the occurrence of scum was observed, but it was at the acceptable level.
BC: Case where the occurrence of scum was large and a long time was needed for washing to remove the scum adhered on the tank wall.
C: Case where the occurrence of scum was severe and the scum adhered on the tank wall could not be removed by washing.

### <Stain resistance>

The lithographic printing plate was subjected to the printing under the condition described above and after printing 10,000 sheets, stain on a blanket corresponding to the non-image area was visually evaluated according to the following criteria:
A: Case where the stain on the blanket was not observed.
AB: Case where the stain on the blanket was hardly observed.
B: Case where the stain on the blanket was slightly observed, but it was at the practicable level.
BC: Case where the stain on the blanket was a little observed.
C: Case where the stain on the blanket was considerably observed.

### <Printing durability>

As increase in the number of printed materials, the image area of the lithographic printing plate was gradually abraded to cause decrease in the ink receptivity, resulting in decrease in ink density of the image on the printed material. A number of printed materials obtained until the ink density (reflection density) decreased by 0.1 from that at the initiation of printing was determined to evaluate the printing durability (just after preparation). Also, after the preparation of the lithographic printing plate, it was allowed to stand under an environment of temperature of 25°C and humidity of 60% for one week and then subjected to the printing under the condition described above to evaluate the printing durability (after one week preservation) in the same manner.

### <Solubility>

At the preparation of the developer, the solubility was visually evaluated according to the following criteria:
A: Case where turbidity of the developer was not observed.
AB: Case where turbidity of the developer was slightly observed.
B: Case where an insoluble matter was present in the developer, but it was dissolved by heating.
BC: Case where an insoluble matter was present in the developer and even after heating the developer was still slightly turbid.
C: Case where an insoluble matter was present in the developer and it was not dissolved by heating.

### <Preservation stability>

The developer prepared was preserved at 45°C or under refrigeration condition (at 5°C) for one month and then the turbidity or separation of the developer was visually evaluated according to the following criteria:
A: Case where the turbidity or separation of the developer was not observed both at 45°C and at 5°C.
AB: Case where the turbidity or separation of the developer was slightly observed at either 45°C or 5°C, but the uniform solution was obtained by lightly stirring.
B: Case where the turbidity or separation of the developer was observed at either 45°C or 5°C, but the uniform solution was obtained by stirring and it was at the acceptable level.
BC: Case where the turbidity or separation of the developer was observed at either 45°C or 5°C and even after stirring the developer was still slightly turbid.
C: Case where the turbidity or separation of the developer was severe at either 45°C or 5°C.

**Table 2**

| | Processing Property | Stain Resistance | Printing Durability (× 10³ sheets)) | | Solubility | Preservation Stability |
|---|---|---|---|---|---|---|
| | | | Just after Preparation | After One Week Preservation | | |
| Example 1 | A | A | 50 | 48 | A | A |
| Example 2 | A | A | 50 | 50 | A | A |
| Example 3 | A | A | 50 | 48 | A | A |
| Example 4 | AB | A | 50 | 49 | A | A |
| Example 5 | AB | A | 48 | 48 | A | A |
| Example 6* | AB | A | 48 | 48 | AB | AB |
| Example 7 | AB | A | 50 | 47 | A | A |
| Example 8 | A | A | 50 | 50 | A | A |
| Example 9 | A | A | 50 | 46 | A | A |
| Example 10* | A | A | 48 | 48 | AB | AB |
| Example 11 * | AB | A | 50 | 50 | AB | AB |
| Example 12^{*} | A | A | 48 | 48 | AB | AB |
| Comparative Example 1 | BC | A | 47 | 45 | A | B |
| Comparative Example 2 | BC | A | 48 | 45 | A | B |
| Comparative Example 3 | BC | A | 50 | 48 | A | B |
| Comparative Example 4 | C | A | 43 | 40 | C | C |
| Comparative Example 5 | C | AB | 35 | 33 | C | C |
| Comparative Example 6 | BC | AB | 48 | 48 | B | BC |
| Comparative Example 7 | C | B | 24 | 26 | C | C |
| Example 13 | AB | A | 50 | 48 | A | A |
| Example 14 | AB | A | 48 | 46 | A | A |
| Example 15* | AB | A | 48 | 46 | AB | AB |
| Example 16 | A | A | 50 | 48 | A | A |
| Example 17 | AB | A | 47 | 48 | A | A |
| Example 18 | AB | A | 49 | 47 | A | A |
| Example 19 | AB | A | 49 | 47 | A | A |
| Example 20 | AB | AB | 48 | 48 | AB | AB |
| Example 21 | A | A | 49 | 48 | A | A |
| Example 22 | AB | A | 50 | 48 | A | AB |
| Example 23 | AB | A | 49 | 49 | A | AB |
| Example 24 | AB | A | 48 | 48 | A | A |
| Example 25* | AB | A | 50 | 48 | AB | AB |
| Example 26 | AB | A | 50 | 47 | A | A |
| Example 27 | A | A | 49 | 49 | A | A |
| Example 28 | AB | A | 50 | 46 | A | AB |
| Example 29* | AB | AB | 47 | 47 | A | A |
| Example 30* | AB | AB | 48 | 48 | A | AB |
| Example 31* | B | A | 47 | 47 | A | B |
| Comparative Example 8 | BC | A | 49 | 49 | A | BC |
| Comparative Example 9 | B | A | 49 | 45 | A | BC |
| Comparative Example 10 | C | C | 41 | 37 | B | C |
| Comparative Example 11 | C | C | 36 | 33 | B | C |
| Comparative Example 12 | C | B | 49 | 49 | B | B |
| Comparative Example 13 | BC | C | 48 | 48 | B | C |
| Comparative Example 14 | C | C | 30 | 28 | B | C |
| Example 32 | A | A | 50 | 49 | A | AB |
| Example 33 | A | A | 47 | 46 | A | AB |
| Example 34* | AB | AB | 46 | 47 | A | AB |
| Example 35 | A | A | 49 | 49 | A | A |
| Example 36 | A | A | 50 | 49 | A | AB |

| | | | | | | |
|---|---|---|---|---|---|---|
| *Outside the scope of the invention | | | | | | |

As is apparent from the results shown in Table 2, the method of preparing a lithographic printing plate according to the invention exhibits good processing property, is prevented from the occurrence of scum in a developing bath, and can provide a lithographic printing plate excellent in stain resistance and printing durability, even with the development processing in a weak acidic to weak alkaline range. Further, the degradation of printing durability due to storage of the lithographic printing plate after the preparation hardly occurs. Moreover, the developer used is also excellent in the preservation stability.

### Examples 37 to 40

Each of Lithographic printing plate precursors 1 and 2 was subjected to image exposure in the same manner as in Example 1 except for changing the plate surface exposure amount to 0.3 mJ/cm². Then, without conducting the preheat treatment, the exposed lithographic printing plate precursor 1 was subjected to the development processing using the developer used in Examples 2 and 13 above and the printing in the same manner as in Example 1, and the exposed lithographic printing plate precursor 2 was subjected to the development processing using the developer used in Examples 21 and 32 above and the printing in the same manner as in Example 1. Good results similar to those in Examples 2, 13, 21 and 32 were obtained, respectively.

## Claims

1. A method for preparing a lithographic printing plate comprising the steps of:
exposing to laser light a lithographic printing plate precursor comprising a support; an image-recording layer containing (A) a sensitizing dye, (B) a polymerization initiator, (C) a polymerizable compound and (D) a binder polymer; and a protective layer in this order; and
removing the protective layer and an unexposed area of the image-recording layer using a developer containing a compound represented by formula (1) below and a compound represented by formula (2) below, wherein the exposed precursor is not subjected to a water washing step before or after the removal step:
X-Y-O-(A1)ₙ₁-(B1)ₘ₁-H (1)
wherein X represents an aromatic group, Y represents a single bond or an alkylene group having 1-10 carbon atoms, A1 and B1 are different from each other and each represents -CH₂CH₂O- or -CH₂CH (CH₃) O-, and n1 and m1 each represents an integer of 0-100, provided that the sum total of n1 and m1 is 12-28;
Z-L-(A2)ₙ₂-(B2)ₘ₂-H (2)
wherein Z represents an alkyl group having 1-20 carbon atoms, L represents -O- or -COC-, A2 and B2 are different from each other and each represents -CH₂CH₂O- or - CH₂CH(CH₃)O-, and n2 and m2 each represents an integer of 0-100, provided that the sum total of n2 and m2 is 12-28.

2. A method according to Claim 1, wherein the ratio of the weight of the compound represented by formula (1) in the developer to the weight of the compound represented by formula (2) in the developer is 1:99-99:1.

3. A method according to Claim 1 or Claim 2, wherein the pH of the developer is 2-11.

4. A method according to any preceding claim, wherein the developer contains an organic solvent.

5. A method according to any preceding claim, wherein the developer contains a carbonate ion and a hydrogen carbonate ion.

6. A method according to any cf Claims 1-4, wherein the developer contains a water-soluble amine and an ammonium ion thereof.

7. A method according to any preceding claim, wherein the developer contains a water-soluble polymer compound.

8. A method according to any preceding claim, wherein the sensitizing dye is at least one of the compounds represented by formulae (V), (VI) and (IX) below: 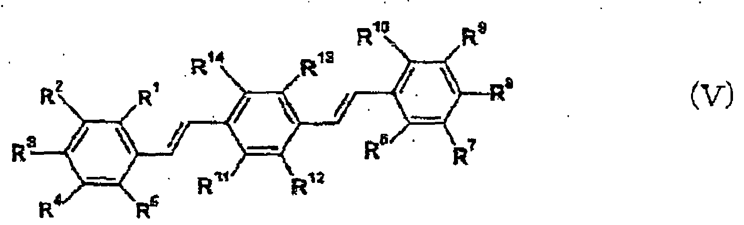 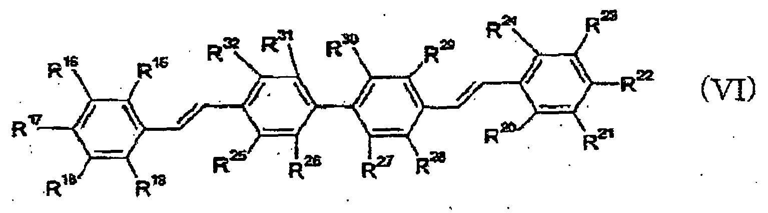 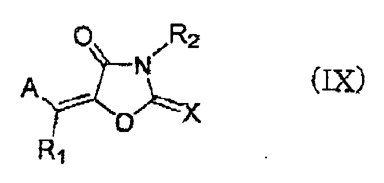 wherein, in formula (V), R¹-R¹⁴ each independently represents a hydrogen atom, an alkyl group, an alkoxy group, a cyano group or a halogen atom, provided that at least one of R¹-R¹⁰ represents an alkoxy group having 2 or more carbon atoms;
in formula (VI), R¹⁵-R³² each independently represents a hydrogen atom, an alkyl group, an alkoxy group, a cyano group or a halogen atom, provided that at least one of R¹⁵-R²⁴ represents an alkoxy group having 2 or more carbon atoms; and
in formula (IX), A represents an aromatic group or a heterocyclic group, X represents an oxygen atom, a sulfur atom or =N(R₃), R₁, R₂ and R₃ each independently represents a monovalent non-metallic atomic group, and A and R₁ or R₂ and R₃ may be combined with each other to form an aliphatic or aromatic ring.

9. A method according to any preceding claim, wherein the binder polymer is a (meth)acrylic polymer or a polyvinyl butyral resin.

10. A developer comprising a compound represented by formula (1) below and a compound represented by formula (2) below:
X-Y-O- (A1)ₙ₁-(B1)ₘ₁-H (1)
wherein X represents an aromatic group, Y represents a single bond or an alkylene group having 1-10 carbon atoms, A1 and B1 are different from each other and each represents -CH₂CH₂C- or -CH₂CH(CH₃)O-, and n1 and m1 each represents an integer of 0-100, provided that the sum total of n1 and m1 is 12-28;
Z-L-(A2)ₙ₂(B2)ₙ₂-H (2)
wherein Z represents an alkyl group having 1-20 carbon atoms, L represents -O- or -COO-, A2 and B2 are different from each other and each represents -CH₂CH₂O- orCH₂CH(CH₃)O-, and n2 and m2 each represents an integer of 0-100, provided that the sum total of n2 and m2 is 12-28.

## Patentansprüche

1. Verfahren zur Herstellung einer Lithographiedruckplatte, umfassend die Schritte:
Belichten eines Lithographiedruckplattenvorläufers, der einen Träger; eine Bildaufzeichnungsschicht, die (A) einen Sensibilisierungsfarbstoff, (B) einen Polymerisationsinitiator, (C) eine polymerisierbare Verbindung und (D) ein Bindepolymer enthält; und eine Schutzschicht in dieser Reihenfolge umfasst; mit Laserlicht; und
Entfernen der Schutzschicht und eines nicht-belichteten Bereichs der Bildaufzeichnungsschicht unter Verwendung eines Entwicklers, der eine durch die nachstehende Formel (1) dargestellte Verbindung und eine durch die nachstehende Formel (2) dargestellte Verbindung enthält, worin der belichtete Vorläufer keinem Wasserwaschschritt vor oder nach dem Entfernungsschritt unterzogen wird:
X-Y-O-(A1)ₙ₁-(B1)ₘ₁-H (1)
worin X eine aromatische Gruppe darstellt, Y eine Einfachbindung oder eine Alkylengruppe mit 1 bis 10 Kohlenstoffatomen darstellt, A1 und B1 voneinander verschieden sind und jeweils -CH₂CH₂O- oder -CH₂CH(CH₃)O- darstellen, und n1 und m1 jeweils eine ganze Zahl von 0 bis 100 darstellen, vorausgesetzt, dass die Gesamtsumme von n1 und m1 12 bis 28 beträgt;
Z-L(A2)ₙ₂-(B2)ₘ₂-H (2)
worin Z eine Alkylgruppe mit 1 bis 20 Kohlenstoffatomen darstellt, L -O- oder -COO- darstellt, A2 und B2 voneinander verschieden sind und jeweils -CH₂CH₂O- oder -CH₂CH(CH₃)O- darstellen, und n2 und m2 jeweils eine ganze Zahl von 0 bis 100 darstellen, vorausgesetzt, dass die Gesamtsumme von n2 und m2 12 bis 28 beträgt.

2. Verfahren gemäß Anspruch 1, worin das Verhältnis des Gewichts der durch die Formel (1) dargestellten Verbindung in dem Entwickler zu dem Gewicht der durch die Formel (2) dargestellten Verbindung in dem Entwickler 1:99 bis 99:1 beträgt.

3. Verfahren gemäß Anspruch 1 oder 2, worin der pH-Wert des Entwicklers von 2 bis 11 beträgt.

4. Verfahren gemäß irgendeinem vorhergehenden Anspruch, worin der Entwickler ein organisches Lösungsmittel enthält.

5. Verfahren gemäß irgendeinem vorhergehenden Anspruch, worin der Entwickler ein Carbonat-Ion und ein Hydrogencarbonat-Ion enthält.

6. Verfahren gemäß irgendeinem der Ansprüche 1 bis 4, worin der Entwickler ein wasserlösliches Amin und ein Ammonium-Ion hiervon enthält.

7. Verfahren gemäß irgendeinem vorhergehenden Anspruch, worin der Entwickler eine wasserlösliche Polymerverbindung enthält.

8. Verfahren gemäß irgendeinem vorhergehenden Anspruch, worin der Sensibilisierungsfarbstoff mindestens eine der durch die nachstehenden Formeln (V), (VI) und (IX) dargestellten Verbindungen ist: 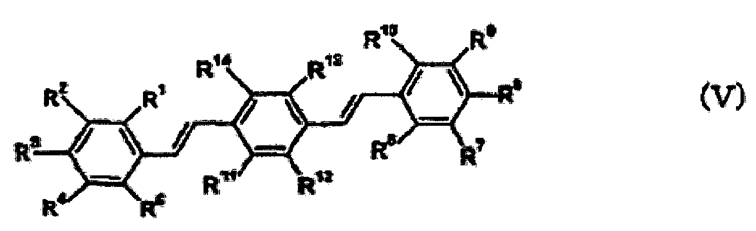 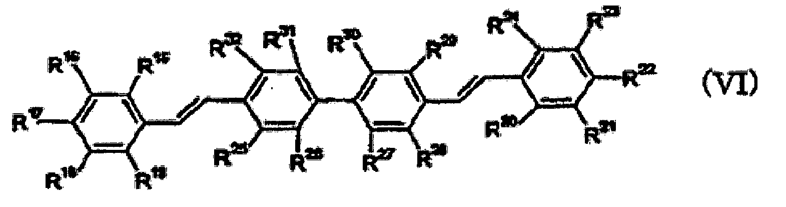 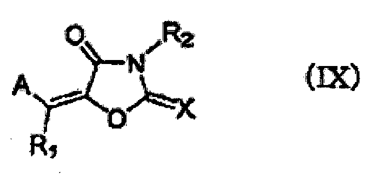 worin in der Formel (V) R¹ bis R¹⁴ jeweils unabhängig ein Wasserstoffatom, eine Alkylgruppe, eine Alkoxygruppe, eine Cyanogruppe oder ein Halogenatom darstellen, vorausgesetzt, dass zumindest eines von R¹ bis R¹⁰ eine Alkoxygruppe mit 2 oder mehr Kohlenstoffatomen darstellt;
in der Formel (VI) R¹⁵ bis R³² jeweils unabhängig ein Wasserstoffatom, eine Alkylgruppe, eine Alkoxygruppe, eine Cyanogruppe oder ein Halogenatom darstellen, vorausgesetzt, dass zumindest eines von R¹⁵ bis R²⁴ eine Alkoxygruppe mit 2 oder mehr Kohlenstoffatomen darstellt; und
in der Formel (IX) A eine aromatische Gruppe oder eine heterocyclische Gruppe darstellt, X ein Sauerstoffatom, ein Schwefelatom oder =N(R₃) darstellt, R₁, R₂ und R₃ jeweils unabhängig eine monovalente nicht-metallische Atomgruppe darstellen, und A und R₁ oder R₂ und R₃ miteinander verbunden sein können, um einen aliphatischen oder aromatischen Ring zu bilden.

9. Verfahren gemäß irgendeinem vorhergehenden Anspruch, worin das Bindepolymer ein (Meth)acrylpolymer oder ein Polyvinylbutyralharz ist.

10. Entwickler, umfassend eine durch die nachstehende Formel (1) dargestellte Verbindung und eine durch die nachstehende Formel (2) dargestellte Verbindung:
X-Y-O-(A1)ₙ₁-(B1)ₘ₁-H (1)
worin X eine aromatische Gruppe darstellt, Y eine Einfachbindung oder eine Alkylengruppe mit 1 bis 10 Kohlenstoffatomen darstellt, A1 und B1 voneinander verschieden sind und jeweils -CH₂CH₂O- oder -CH₂CH(CH₃)O- darstellen, und n1 und m1 jeweils eine ganze Zahl von 0 bis 100 darstellen, vorausgesetzt, dass die Gesamtsumme von n1 und m1 12 bis 28 beträgt;
Z-L(A2)ₙ₂-(B2)ₘ₂-H (2)
worin Z eine Alkylgruppe mit 1 bis 20 Kohlenstoffatomen darstellt, L -O- oder -COO- darstellt, A2 und B2 voneinander verschieden sind und jeweils -CH₂CH₂O- oder -CH₂CH(CH₃)O- darstellen, und n2 und m2 jeweils eine ganze Zahl von 0 bis 100 darstellen, vorausgesetzt, dass die Gesamtsumme von n2 und m2 12 bis 28 beträgt.

## Revendications

1. Procédé de préparation d'une plaque d'impression lithographique comprenant les étapes consistant à :
exposer à une lumière laser un précurseur de plaque d'impression lithographique comprenant un support ; une couche d'enregistrement d'image contenant (A) un colorant sensibilisateur, (B) un initiateur de polymérisation, (C) un composé polymérisable et (D) un polymère liant ; et une couche protectrice dans cet ordre ; et
éliminer la couche protectrice et une zone non exposée de la couche d'enregistrement d'image à l'aide d'un révélateur contenant un composé représenté par la formule (1) ci-dessous et un composé représenté par la formule (2) ci-dessous, le précurseur exposé n'étant pas soumis à une étape de lavage à l'eau avant ou après l'étape d'élimination :
**X-Y-O-(A1)ₙ₁-(B1)ₘ₁-H** (1)
dans laquelle X représente un groupe aromatique, Y représente une simple liaison ou un groupe alkylène comportant 1 à 10 atomes de carbone, A1 et B1 sont différents l'un de l'autre et représentent chacun -CH₂CH₂O- ou -CH₂CH(CH₃)O- et n1 et m1 représentent chacun un nombre entier de 0 à 100, à condition que la somme totale de n1 et m1 soit de 12 à 28 ;
**z-L-(A2)ₙ₂-(B2)ₘ₂-H** (2) dans laquelle Z représente un groupe alkyle comportant 1 à 20 atomes de carbone, L représente -O- ou -COO-, A2 et B2 sont différents l'un de l'autre et chacun représente -CH₂CH₂O- ou -CH₂CH(CH₃)O-, et n2 et m2 représentent chacun un nombre entier de 0 à 100, à condition que la somme totale de n2 et m2 soit de 12 à 28.

2. Procédé selon la revendication 1, dans lequel le rapport entre le poids du composé représenté par la formule (1) dans le révélateur et le poids du composé représenté par la formule (2) dans le révélateur est de 1:99 à 99:1.

3. Procédé selon la revendication 1 ou la revendication 2, dans lequel le pH du révélateur est de 2 à 11.

4. Procédé selon l'une quelconque des revendications précédentes, dans lequel le révélateur contient un solvant organique.

5. Procédé selon l'une quelconque des revendications précédentes, dans lequel le révélateur contient un ion carbonate et un ion hydrogénocarbonate.

6. Procédé selon l'une quelconque des revendications 1 à 4, dans lequel le révélateur contient une amine soluble dans l'eau et un ion ammonium de celle-ci.

7. Procédé selon l'une quelconque des revendications précédentes, dans lequel le révélateur contient un composé polymère soluble dans l'eau.

8. Procédé selon l'une quelconque des revendications précédentes, dans lequel le colorant sensibilisateur est au moins l'un des composés représentés par les formules (V), (VI) et (IX) ci-dessous : 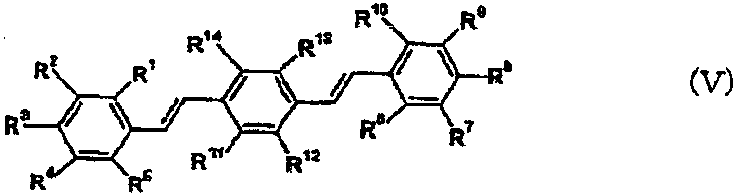 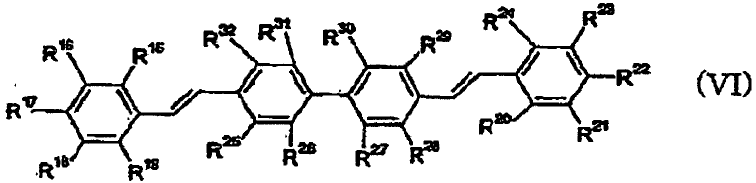 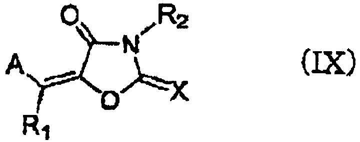 dans lesquelles, dans la formule (V), R¹ à R¹⁴ représentent chacun indépendamment un atome d'hydrogène, un groupe alkyle, un groupe alcoxy, un groupe cyano ou un atome d'halogène, à condition qu'au moins l'un de R¹ à R¹⁰ représente un groupe alcoxy comportant 2 atomes de carbone ou plus ;
dans la formule (VI), R¹⁵ à R³² représentent chacun indépendamment un atome d'hydrogène, un groupe alkyle, un groupe alcoxy, un groupe cyano ou un atome d'halogène, à condition qu'au moins l'un de R¹⁵ à R²⁴ représente un groupe alcoxy comportant 2 atomes de carbone ou plus ; et,
dans la formule (IX), A représente un groupe aromatique ou un groupe hétérocyclique, X représente un atome d'oxygène, un atome de soufre ou =N(R₃), R₁, R₂ et R₃ représentent chacun indépendamment un groupe atomique non métallique monovalent et A et R₁ ou R₂ et R₃ peuvent être combinés les uns aux autres pour former un cycle aliphatique ou aromatique.

9. Procédé selon l'une quelconque des revendications précédentes, dans lequel le polymère liant est un polymère (méth)acrylique ou une résine de poly(vinyl butyral).

10. Révélateur comprenant un composé représenté par la formule (1) ci-dessous et un composé représenté par la formule (2) ci-dessous :
**X-Y-O-(A1)ₙ₁-(B1)ₘ₁-H** (1)
dans laquelle X représente un groupe aromatique, Y représente une simple liaison ou un groupe alkylène comportant 1 à 10 atomes de carbone, A1 et B1 sont différents l'un de l'autre et représentent chacun -CH₂CH₂O- ou -CH₂CH(CH₃)O-, et n1 et m1 représentent chacun un nombre entier de 0 à 100, à condition que la somme totale de n1 et m1 soit de 12 à 28 ;
**Z-L-(A2)ₙ₂(B2)ₙ₂-H** (2)
dans laquelle Z représente un groupe alkyle comportant 1 à 20 atomes de carbone, L représente -O- ou -COO-, A2 et B2 sont différents l'un de l'autre et chacun représente -CH₂CH₂O- ou -CH₂CH(CH₃)O-, et n2 et m2 représentent chacun un nombre entier de 0 à 100, à condition que la somme totale de n2 et m2 soit de 12 à 28.
